(19) **Europäisches Patentamt**

**European Patent Office**

**Office européen des brevets**

(11) **EP 0 723 173 B1**

(12) **EUROPEAN PATENT SPECIFICATION**

(45) Date of publication and mention
of the grant of the patent:
**05.11.2003 Bulletin 2003/45**

(51) Int Cl.$^7$: **G02B 13/22**, G03F 7/20,
G02B 13/14, G02B 13/24,
G02B 13/26, G02B 17/08

(21) Application number: **96100719.2**

(22) Date of filing: **18.01.1996**

(54) **Exposure apparatus**

Belichtungsvorrichtung

Appareil d'exposition

(84) Designated Contracting States:
**DE FR GB IT NL**

(30) Priority: **18.01.1995 JP 583595**
**02.06.1995 JP 13677995**

(43) Date of publication of application:
**24.07.1996 Bulletin 1996/30**

(73) Proprietor: **NIKON CORPORATION**
**Tokyo 100 (JP)**

(72) Inventor: **Kumazawa, Masato**
**Kawasaki-shi, Kanagawa-ken (JP)**

(74) Representative:
**Ritter und Edler von Fischern, Bernhard,**
**Dipl.-Ing. et al**
**Hoffmann Eitle,**
**Patent- und Rechtsanwälte,**
**Arabellastrasse 4**
**81925 München (DE)**

(56) References cited:
**EP-A- 0 313 200**        **WO-A-93/09467**
**WO-A-96/25681**       **JP-A- 7 326 557**
**US-A- 4 171 871**       **US-A- 5 369 521**

**Description**

BACKGROUND OF THE INVENTION

Field of the Invention

The present invention relates to a scanning exposure apparatus for performing an exposure operation while moving a first object (e.g., a mask or a reticle) and a second object (e.g., a substrate).

Related Background Art

In recent years, liquid crystal display panels are popularly used as display elements for wordprocessors, personal computers, television sets, and the like. To manufacture such a liquid crystal display panel, a transparent thin-film electrode is patterned into a desired shape on a glass substrate by photolithography.

As an apparatus for performing lithography, e.g., a mirror projection type aligner is known.

Recently, large-sized liquid crystal display panels are demanded, and an increase in exposure area is required for such an aligner.

SUMMARY OF THE INVENTION

It is an object of the present invention to provide a compact and high-performance exposure apparatus which can perform a projection exposure operation with satisfactory optical performance by using a plurality of compact projection optical systems each capable of ensuring a sufficient working distance and having excellent imaging performance, while preventing a decrease in throughput even in a large exposure area.

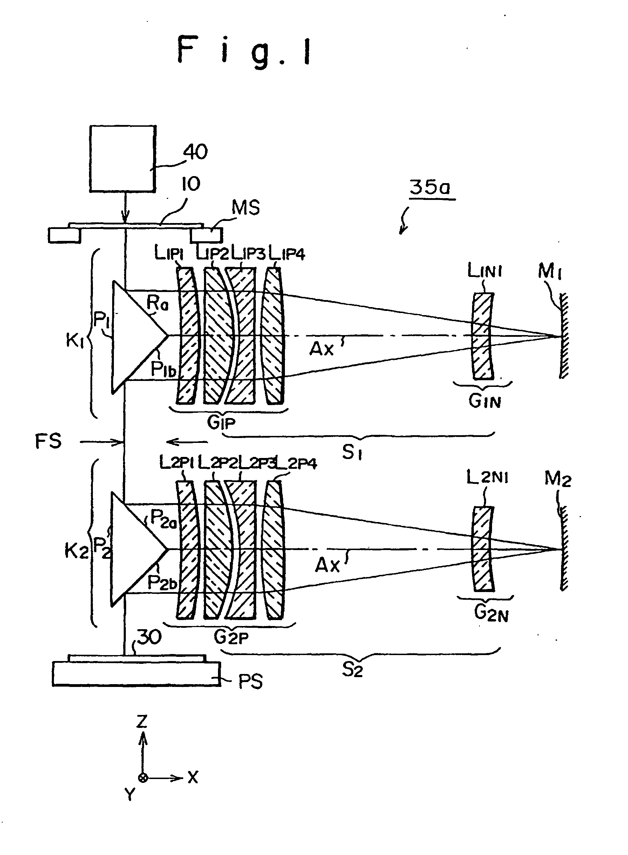

The invention is defined in claim 1. According to the present invention, as shown in Fig. 1, there is provided an exposure apparatus for projecting and exposing an image of a first object onto a second object while moving the first object and the second object, comprising first and second both-side telecentric projection optical systems for forming a real-size erect image of the first object on the second object, wherein each of the first and second projection optical systems has a first imaging optical system for condensing a light beam from the first object to form a primary image, and a second imaging optical system for condensing the light beam from the primary image to form a secondary image, the first imaging optical system has a first positive lens group having a positive refracting power, a first negative lens group having a negative refracting power, and a first concave reflecting mirror such that the light beam from the first object is reflected by the first concave reflecting mirror through the first positive lens group and the first negative lens group and passes through the first negative lens group and the first positive lens group again, thereby forming the primary image, and the second imaging optical system has a second positive lens group having a positive refracting power, a second negative lens group having a negative refracting power, and a second concave reflecting mirror such that the light beam from the first object is reflected by the second concave reflecting mirror through the second positive lens group and the second negative lens group and passes through the second negative lens group and the second positive lens group again, thereby forming the secondary image.

When the focal length of the first positive lens group (and/or the second positive lens group) is $f_{GP}$, and the focal length of the first negative lens group (and/or the second negative lens group) is $f_{GN}$, the first and/or second imaging optical system preferably satisfies the following relation:

$$3 < | f_{GN}/f_{GP}| \,.$$

On the basis of the above arrangement, the first negative lens group preferably includes a negative meniscus lens having a convex surface facing the first positive lens group side, and the second negative lens group preferably includes a negative meniscus lens having a convex surface facing the second positive lens group side.

The first and/or second imaging optical system constituting the projection optical system preferably includes a negative meniscus lens having a convex surface facing a first positive lens group side (and/or a second positive lens group side). When the radius of curvature of a lens surface of the negative meniscus lens on the first positive lens group side (and/or the second positive lens group side) is $r_{1N}$, the radius of curvature of a lens surface of the negative meniscus lens on a first concave reflecting mirror side (and/or a second concave reflecting mirror side) is $r_{2N}$, and the distance on an optical axis from an image-side principal point to the first concave reflecting mirror, which image side corresponds to the first concave reflecting mirror side of the negative meniscus lens (and/or the distance on the optical axis from an image-side principal point to the second concave reflecting mirror, which image side corresponds to the first concave reflecting mirror side), is $L_{NM}$, the following relations are preferably satisfied:

$$-30 < q < -3$$

$$-4 < L_{NM}/TL < 0.2$$

where a shape factor q is represented as $q = (r_{2N} + r_{1N})/(r_{2N} - r_{1N})$.

When the distance from an image-side principal point, which image side corresponds to the first concave reflecting mirror side of the first positive lens group, to an image-side principal point, which image side corresponds to the first concave reflecting mirror side of the first negative lens group (and/or the distance from an image-side principal point, which image side corresponds to the second concave reflecting mirror side of the second positive lens group, to an image-side principal point, which image side corresponds to the second concave reflecting mirror side of the second negative lens group) is $L_{GP-GN}$, and the distance (total length) on the optical axis from an object surface O to the first concave reflecting mirror (and/or the second concave reflecting mirror) is TL, the first and/or second imaging optical system constituting the projecting optical system preferably satisfies the following relation:

$$0.35 < L_{GP-GN}/TL.$$

When the focal length of the first positive lens group (and/or the second positive lens group) is $f_{GP}$, the distance (total length) on the optical axis from the object surface O to the first concave reflecting mirror (and/or the second concave reflecting mirror) is TL, and the radius of curvature of the first concave reflecting mirror (and/or the second concave reflecting mirror) is $r_M$, the first and/or second imaging optical system constituting the projection optical system preferably satisfies the following relations:

$$0.95 < | r_M/TL| < 1.08$$

$$0.3 < f_{GP}/TL < 1.0.$$

The first negative lens group may have a positive lens and a negative meniscus lens having a concave surface facing the first positive lens group side, in an order from the first positive lens group side, and the second negative lens group may have a positive lens and a negative meniscus lens having a concave surface facing the second positive lens group side, in an order from the second positive lens group side. In this case, the negative meniscus lens in the first negative lens group is preferably bonded to the first concave reflecting mirror, and the negative meniscus lens in the second negative lens group is preferably bonded to the second concave reflecting mirror.

With the above arrangement, scanning exposure of the first object (e.g., a mask or a reticle) and the second object (e.g., a substrate) can be performed in a wide range with satisfactory optical performance of the projection optical system while ensuring a high throughput. Particularly, in the present invention, since the negative lens group in the first or second imaging optical system is arranged in the optical path between the positive lens group and the concave reflecting mirror, a sufficient working distance can be ensured.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

BRIEF DESCRIPTION OF THE DRAWINGS

Fig. 1 is a view showing the arrangement of a projection optical system according to an embodiment of the present invention.

Figs. 2A, 2B and 2C show the relationship between an exposure area and a field stop of the projection optical system.

Fig. 3 is a view schematically showing an exposure apparatus according to the present invention.
Fig. 4 is a view showing the lens arrangement of a projection optical system according to the first embodiment.
Figs. 5A, 5B and 5C are views showing various aberrations of the projection optical system shown in Fig. 4.
Fig. 6 is a view showing the lens arrangement of a projection optical system constituted as a Dyson optical system.
Fig. 7 is a view showing the lens arrangement of a projection optical system according to the second embodiment.
Figs. 8A, 8B and 8C are views showing various aberrations of the projection optical system shown in Fig. 7.
Fig. 9 is a view showing the lens arrangement of a projection optical system according to the third embodiment.
Figs. 10A, 10B and 10C are views showing various aberrations of the projection optical system shown in Fig. 9.
Fig. 11 is a view showing the lens arrangement of a projection optical system according to the fourth embodiment.
Figs. 12A, 12B and 12C are views showing various aberrations of the projection optical system shown in Fig. 11.
Fig. 13 is a view showing the lens arrangement of a projection optical system according to the fifth embodiment.
Figs. 14A, 14B and 14C are views showing various aberrations of the projection optical system shown in Fig. 13.
Fig. 15 is a view showing the lens arrangement of a projection optical system according to the sixth embodiment.
Figs. 16A, 16B and 16C are views showing various aberrations of the projection optical system shown in Fig. 15.
Fig. 17 is a view showing the lens arrangement of a projection optical system according to the seventh embodiment.
Figs. 18A, 18B and 18C are views showing various aberrations of the projection optical system shown in Fig. 17.
Fig. 19 is a view showing the lens arrangement of a projection optical system according to the eighth embodiment.
Figs. 20A, 20B and 20C are views showing various aberrations of the projection optical system shown in Fig. 19.
Fig. 21 is a view showing the lens arrangement of a projection optical system according to the ninth embodiment.
Figs. 22A, 22B and 22C are views showing various aberrations of the projection optical system shown in Fig. 21.
Fig. 23 is a view showing an arrangement using a projection optical system of the tenth embodiment.
Fig. 24 is a view showing the lens arrangement of a projection optical system according to the tenth embodiment.
Figs. 25A and 25B show a modification of a prism member in the tenth embodiment.
Figs. 26A, 26B and 26C are views showing various aberrations of the projection optical system shown in Fig. 24.

## DESCRIPTION OF THE PREFERRED EMBODIMENTS

In the above-described aligner type projection exposure apparatus, the exposure area is increased by joining small exposure areas. In this case, to obtain a large exposure area, the exposure operation must be performed a number of times, resulting in a decrease in throughput (the number of substrates exposed per unit time). Since the joint accuracy between adjacent exposure areas must be increased, the magnification error or distortion in the projection optical system must be almost zero. In addition, the alignment accuracy must be largely increased, resulting in an increase in cost of the apparatus.

To increase the exposure area, a technique can be used in which a large projection optical system is formed to perform one-shot exposure of a large exposure area. In this case, however, large optical elements constituting the projection optical system must be accurately manufactured. This may result in an increase in manufacturing cost and an increase in size of the exposure apparatus. When the projection optical system becomes bulky, optical aberrations may increase accordingly.

As a projection optical system of an exposure apparatus for performing scanning exposure of a pattern formed on a mask by photolithography onto a substrate through the real-size projection optical system (with a magnification of 1), a projection optical system using a Dyson optical system is disclosed in, e.g., International Patent Laid-Open No. 57-502067.

In the Dyson optical system disclosed in International Patent Laid-Open No. 57-502067, however, the distance from the position of an object (or an image) to the optical system, i.e., the so-called working distance can hardly be sufficiently ensured. For this reason, an acute angle is formed by the mask and the substrate, so the mask and the substrate cannot be set almost parallel to each other, resulting in a significant limitation in scanning range. In addition, the arrangement of stages for holding the mask and the substrate is largely limited. Furthermore, a member for adjusting the optical performance of the projection optical system can hardly be inserted in a space within the working distance.

Embodiments according to the present invention will be described below with reference to the accompanying drawings. Fig. 1 is a view schematically showing the projection optical system of an exposure apparatus according to the present invention. In Fig. 1, a direction (scanning direction) for conveying a mask 10 with a predetermined circuit pattern formed thereon and a plate 30 as a glass substrate coated with a resist is set along the X-axis, a direction perpendicular to the X-axis in the plane of the mask 10 is set along the Y-axis, and the normal direction of the mask 10 is set along the Z-axis. Fig. 1 shows only a first projection optical system 35a.

Referring to Fig. 1, the first projection optical system 35a has a first imaging optical system $K_1$ for forming the primary image of the circuit pattern on the mask 10, and a second imaging optical system $K_2$ for forming the erect image (secondary image) of the circuit pattern onto the plate 30 on the basis of a light beam from the primary image. The first imaging optical system $K_1$ has a rectangular prism $P_1$ (first reflecting member) having reflecting surfaces $P_{1a}$

and $P_{1b}$ inclined by 45° with respect to the plane (X-Y plane) of the mask 10, a first refraction optical system $S_1$ consisting of a first positive lens group $G_{1P}$ and a first negative lens group $G_{1N}$, and a first concave reflecting mirror $M_1$.

The first positive lens group $G_{1P}$ comprises a positive meniscus lens $L_{1P1}$ having its convex surface facing the first concave reflecting mirror $M_1$ side, a positive lens $L_{1P2}$ having its surface with a larger curvature facing the first concave reflecting mirror $M_1$ side, a negative meniscus lens $L_{1P3}$ having its convex surface facing the first concave reflecting mirror $M_1$ side, and a biconvex positive lens $L_{1P4}$. The first negative lens group $G_{1N}$ comprises only a negative meniscus lens $L_{1N1}$ having its convex surface facing the first positive lens group $G_{1P}$ side.

The arrangement of the second imaging optical system $K_2$ is the same as that of the first imaging optical system $K_1$. More specifically, the second imaging optical system $K_2$ has a rectangular prism $P_2$ (second reflecting member) having reflecting surfaces $P_{2a}$ and $P_{2b}$ inclined by 45° with respect to the plane (X-Y plane) of the plate 30, a second refraction optical system $S_2$ consisting of a second positive lens group $G_{2P}$ and a second negative lens group $G_{2N}$, and a second concave reflecting mirror $M_2$.

As in the first positive lens group $G_{1P}$, the second positive lens group $G_{2P}$ comprises a positive meniscus lens $L_{2P1}$ having its convex surface facing the second concave reflecting mirror $M_2$ side, a positive lens $L_{2P2}$ having its surface with a larger curvature facing the second concave reflecting mirror $M_2$ side, a negative meniscus lens $L_{2P3}$ having its convex surface facing the second concave reflecting mirror $M_2$ side, and a biconvex positive lens $L_{2P4}$. The second negative lens group $G_{2N}$ comprises only a negative meniscus lens $L_{2N1}$ having its convex surface facing the second positive lens group $G_{2P}$ side.

A field stop FS for defining the projection area on the plate 30 is provided at the position where the primary image of the circuit pattern is formed by the first imaging optical system $K_1$.

The circuit pattern on the mask 10 is illuminated with an illumination light beam (exposure light beam) from an illumination optical system 40 at an almost uniform illuminance. The light beam passing through the circuit pattern propagates along the -Z direction in Fig. 1, is deflected by 90° by the reflecting surface $P_{1a}$ of the rectangular prism $P_1$, propagates along the +X direction in Fig. 1, and is incident on the first positive lens group $G_{1P}$ ($L_{1P1}$ to $L_{1P4}$). The light beam incident on the first positive lens group $G_{1P}$ ($L_{1P1}$ to $L_{1P4}$) reaches the first concave reflecting mirror $M_1$ through the first negative lens group $G_{1N}$ ($L_{1N1}$). The first concave reflecting mirror $M_1$ is arranged almost at the rear focal position of the first refraction optical system $S_1$ ($G_{1P}$ and $G_{1N}$). That is, the first concave reflecting mirror $M_1$ is located at the pupil plane of the first imaging optical system $K_1$. The rear focal position of the first refraction optical system $S_1$ is obtained when the rectangular prism $P_1$ side is defined as a front side, and the first concave reflecting mirror $M_1$ side is defined as a rear side.

The light beam reflected by the first concave reflecting mirror $M_1$ propagates along the -X direction in Fig. 1 through the first negative lens group $G_{1N}$ ($L_{1N1}$) and the first positive lens group $G_{1P}$ ($L_{1P1}$ to $L_{1P4}$) toward the reflecting surface $P_{1b}$ of the rectangular prism $P_1$. The refracting power received by the light beam incident from the positive meniscus lens $L_{1P1}$ side toward the first concave reflecting mirror $M_1$ is almost equal to that received by the light beam incident from the first concave reflecting mirror $M_1$ side and exiting from the positive meniscus lens $L_{1P1}$.

The light beam reaching the reflecting surface $P_{1b}$ of the rectangular prism $P_1$ is deflected by about 90° by the reflecting surface $P_{1b}$, propagates along the -Z direction in Fig. 1, and forms the primary image of the circuit pattern at the position of the field stop FS. In this primary image, the transverse magnification in the X direction is almost +1 time, and the transverse magnification in the Y direction is almost -1 time.

The light beam from the primary image forms the secondary image of the circuit pattern onto the plate 30 through the second imaging optical system $K_2$. The transverse magnifications in the X and Y directions of this secondary image are almost +1 time. That is, the secondary image formed on the plate 30 is an erect image. The function of the second imaging optical system $K_2$ is the same as that of the first imaging optical system $K_1$, and a detailed description thereof will be omitted.

Since the image of the circuit pattern, which is formed on the plate 30, is an erect image, scanning exposure can be performed by integrally moving the mask 10 held by a mask stage MS and the plate 30 held by a plate stage PS in the same direction.

The first imaging optical system $K_1$ is telecentric on the mask 10 side and on the field stop FS side because the first concave reflecting mirror $M_1$ is arranged at the rear focal position of the first refraction optical system $S_1$. Similarly, the second imaging optical system $K_2$ is telecentric on the field stop FS side and on the plate 30 side because the second concave reflecting mirror $M_2$ is arranged at the rear focal position of the first refraction optical system $S_2$. Therefore, the first projection optical system 35a is a both-side telecentric optical system (on the mask 10 side and on the plate 30 side).

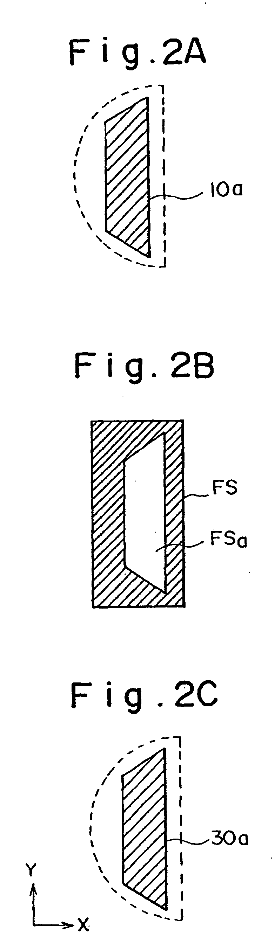

The exposure area of the first projection optical system 35a shown in Fig. 1 will be described below with reference to Figs. 2A, 2B and 2C. Fig. 2A is a plan view showing the relationship between the effective field area and the field in the X-Y plane on the mask 10 in the first projection optical system 35a. Fig. 2B is a plan view of the field stop FS. Fig. 2C is a plan view showing the relationship between the effective exposure area and the exposure area in the first projection optical system 35a.

Referring to Fig. 2A, the effective field area as the maximum field area acquirable in the first projection optical system 35a is a semicircular area surrounded by a broken line on the mask 10. When an opening portion FSa of the field stop FS has a trapezoidal shape, as shown in Fig. 2B, a field area 10a on the mask 10 in the first projection optical system 35a has a trapezoidal shape similar to that of the opening portion FSa. The field area 10a is naturally included in the effective field area.

As shown in Fig. 2C, the effective exposure area as the maximum exposure area acquirable on the plate 30 in the first projection optical system 35a is a semicircular area surrounded by a broken line. An exposure area 30a on the plate 30 is defined as a trapezoidal shape similar to the opening portion FSa by the opening portion FSa of the field stop FS. The exposure area 30a is included in the effective exposure area. In the trapezoidal exposure area 30a, the height of the trapezoid in the X direction corresponds to the slit width, and an oblique side portion at the end portion in the Y direction (a portion where the height along the X direction changes) corresponds to an overlap area (an area overlapping an adjacent exposure area in the Y direction).

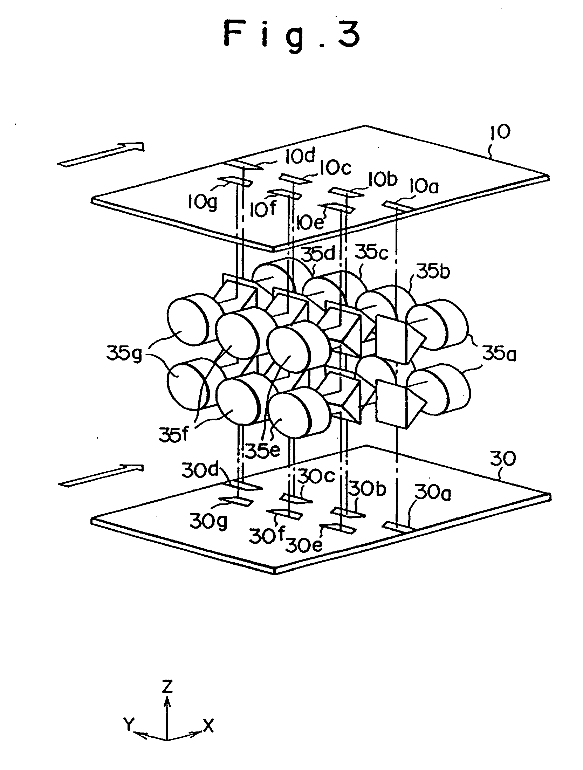

The overall arrangement of the exposure apparatus according to the present invention will be described below with reference to Fig. 3. Fig. 3 is a view schematically showing an example of the exposure apparatus according to the present invention. In Fig. 3, the illumination optical system 40 shown in Fig. 1, the mask stage for supporting the mask 10, and the plate stage for supporting the plate 30 are not illustrated.

Referring to Fig. 3, four projection optical systems 35a to 35d and three projection optical systems 35e to 35g are arranged along the Y direction between the mask 10 and the plate 30. The projection optical systems 35a to 35d and the projection optical systems 35e to 35g are arranged at different positions in the X direction. Each of the projection optical systems 35a to 35g has the same arrangement as that of the first projection optical system 35a described in Fig. 1, and a detailed description thereof will be omitted.

Field areas 10a to 10g formed by the projection optical systems 35a to 35g are trapezoidal. The short sides of the field areas 10a to 10d formed by the projection optical systems 35a to 35d oppose those of the field areas 10e to 10g formed by the projection optical systems 35e to 35g. Therefore, exposure areas 30a to 30g formed on the plate 30 by the projection optical systems 35a to 35g are trapezoidal. The sum of the scanning direction (X direction) lengths of the exposure areas 30a to 30g is constant at any position in the direction (Y direction) perpendicular to the scanning direction. More specifically, the projection optical systems are arranged such that the areas of the exposure areas 30a to 30g overlap in the Y direction.

Since the erect images of the field areas 10a to 10g are formed in the exposure areas 30a to 30g, respectively, the image of the mask 10 is sequentially formed on the plate 30 by scanning the mask 10 and the plate 30 along the scanning direction.

In Fig. 3, the seven projection optical systems 35a to 35g are used. However, in the exposure apparatus according to the present invention, the number of projection optical systems is not limited to seven, and two (the first projection optical system and the second projection optical system) or more projection optical systems can be arranged.

To reduce deflection of the mask 10 and the plate 30 due to the gravity, the direction (Y direction) perpendicular to the scanning direction is preferably set along the vertical direction. Alternatively, the scanning direction (X direction) can be set along the vertical direction. In this case, however, scanning is performed against the gravity, so the load on the mask stage and the plate stage undesirably increases.

The overall arrangement of this embodiment has been described above. A preferred example of the projection optical system of this embodiment shown in Fig. 1 will be described below.

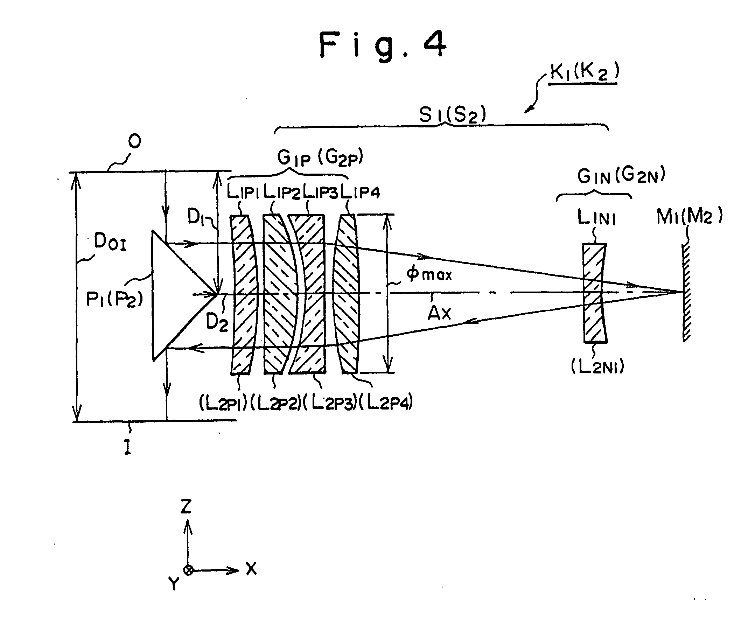

Fig. 4 is a view showing the lens arrangement of the first imaging optical system $K_1$ (or the second imaging optical system $K_2$) shown in Fig. 1. For the descriptive convenience, the lens arrangement shown in Fig. 4 will be described as that of the first imaging optical system $K_1$.

In the embodiment shown in Fig. 4, when the working distance of the first imaging optical system $K_1$ is WD, the distance from an object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$) is $D_1$, the distance from the vertex of the rectangular prism $P_1$ to the vertex of the positive meniscus lens $L_{1P1}$ on the prism $P_1$ side is $D_2$, and the distance from the object surface O (mask) to an image surface I (primary image surface) is $D_{0I}$, the following relations are established:

$$(I) \qquad WD = D_1 + D_2$$

$$(II) \qquad D_{0I} = 2D_1$$

For this reason, to ensure a sufficient working distance in the first or second imaging optical system ($K_1$ or $K_2$) constituting the projection optical system, the following relation (1) is preferably satisfied when the maximum outer diameter of the first or second imaging optical system $K_1$ or $K_2$ is $\Phi$max:

$$(1) \qquad 2(WD - D_2)/\Phi max > 1$$

When relation (1) is satisfied, a sufficient space can be obtained in the Z direction of the mask 10, the plate 30, and the first and second imaging optical systems ($K_1$ and $K_2$). Therefore, a correction optical member for adjusting the optical performance including the magnification of the entire projection optical system can be arranged between the mask 10 and the first rectangular prism $P_1$, between the first rectangular prism $P_1$ and the second rectangular prism $P_2$, or between the second rectangular prism $P_2$ and the plate 30. In addition, the spatial limitation in arrangement of the stages for holding the mask 10 and the plate 30 can be largely decreased.

When the focal length of the first positive lens group $G_{1P}$ (or the second positive lens group $G_{2P}$) is $f_{GP}$, and the focal length of the first negative lens group $G_{1N}$ (or the second negative lens group $G_{2N}$) is $f_{GN}$, the first or second imaging optical system ($K_1$ or $K_2$) constituting the projection optical system preferably satisfies the following relation:

$$(2) \qquad 3 < |f_{GN}/f_{GP}|$$

Relation (2) is a condition for satisfactorily correcting a spherical aberration when a sufficient working distance is ensured. If $|f_{GN}/f_{GP}|$ is below the lower limit of relation (2), the refracting power of the first negative lens group $G_{1N}$ (or the second negative lens group $G_{2N}$) becomes too strong, and the spherical aberration is undesirably excessively corrected. As for the aberration in this embodiment, the propagation direction of the light beam is defined as the positive direction.

The first or second negative lens group in the first or second imaging optical system ($K_1$ or $K_2$) constituting the projection optical system is preferably constituted by a negative meniscus lens. When the radius of curvature of the lens surface of the negative meniscus lens on the first positive lens group side (or on the second positive lens group side) is $r_{1N}$, the radius of curvature of the lens surface of the negative meniscus lens on the first concave reflecting mirror side (or on the second concave reflecting mirror side) is $r_{2N}$, and the distance on the optical axis from the image-side principal point to the first concave reflecting mirror, which image side corresponds to the first concave reflecting mirror side of the negative meniscus lens (or the distance on the optical axis from the image-side principal point to the second concave reflecting mirror, which image side corresponds to the second concave reflecting mirror side) is $L_{NM}$, the following relations are preferably satisfied:

$$(3) \qquad -30 < q < -3$$

$$(4) \qquad -4 < L_{NM}/TL < 0.2$$

A shape factor q is represented as $q = (r_{2N} + r_{1N})/(r_{2N} - r_{1N})$.

Relations (3) and (4) are conditions for satisfactorily correcting the spherical aberration when a sufficient working distance is ensured. If q is below the lower limit of relation (3), the spherical aberration is undesirably excessively corrected. If q exceeds the upper limit of relation (3), the spherical aberration is undesirably insufficiently corrected.

On the other hand, if $L_{NM}/TL$ is below the lower limit of relation (4), the image surface is curved in the positive direction, and the spherical aberration is undesirably excessively corrected. If $L_{NM}/TL$ exceeds the upper limit of relation (4), the image surface is curved in the negative direction, and the spherical aberration is undesirably insufficiently corrected.

To keep the image surface flat while suppressing the spherical aberration when a sufficient working distance is ensured, when the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$ (or the distance from the image-side principal point, which image side corresponds to the second concave reflecting mirror $M_2$ side of the second positive lens group $G_{2P}$, to the image-side principal point, which image side corresponds to the second concave reflecting mirror $M_2$ side of the second negative lens group $G_{2N}$) is $L_{GP-GN}$, and the distance (total length) on the optical axis AX from the object surface O to the first concave reflecting mirror $M_1$ (or the second concave reflecting mirror $M_2$) is TL, the first or second imaging optical system ($K_1$ or $K_2$) constituting the projection optical system preferable satisfies the following relation:

$$(5) \qquad 0.35 < L_{GP-GN}/TL$$

If $L_{GP-GN}/TL$ is below the lower limit of relation (5), the spherical aberration is insufficiently corrected, and the image surface is undesirably curved in the negative direction.

When the focal length of the first positive lens group $G_{1P}$ (or the second positive lens group $G_{2P}$) is $f_{GP}$, the distance (total length) on the optical axis AX from the object surface O to the first concave reflecting mirror $M_1$ (or the second concave reflecting mirror $M_2$) is TL, and the radius of curvature of the first concave reflecting mirror $M_1$ (or the second concave reflecting mirror $M_2$) is $r_M$, the first or second imaging optical system $K_1$ or $K_2$ constituting the projection optical system preferably satisfies the following relations:

$$(6) \qquad 0.95 < |\,r_M/TL| < 1.08$$

$$(7) \qquad 0.3 < f_{GP}/TL < 1.0$$

Relations (6) and (7) are conditions for suppressing the astigmatism and the curvature of field when a sufficient working distance is ensured. If $|\,r_M/TL|$ is below the lower limit of relation (6), the astigmatism is generated, and the image surface is undesirably curved in the negative direction. If $|\,r_M/TL|$ exceeds the upper limit of relation (6), the astigmatism is generated, and the image surface is undesirably curved in the positive direction. To suppress an insufficiently corrected spherical aberration, in addition to the astigmatism and the curvature of field, the upper limit of relation (6) is preferably set at 1.05, i.e., $|\,r_M/TL| < 1.05$.

If $f_{GP}/TL$ is below the lower limit of relation (7), the astigmatism is generated even when relation (6) is satisfied, and the image surface is undesirably curved in the negative direction. To suppress the astigmatism, the curvature of field, and the insufficiently corrected spherical aberration to obtain satisfactory imaging performance, the lower limit of relation (7) is preferably set at 0.5, i.e., $0.5 < f_{GP}/TL$. If $f_{GP}/TL$ exceeds the upper limit of relation (7), the astigmatism is generated, and the image surface is undesirably curved in the positive direction. To suppress the excessively corrected spherical aberration, in addition to the astigmatism and the curvature of field, to obtain satisfactory imaging performance, the upper limit of relation (7) is preferably set at 0.8, i.e., $f_{GP}/TL < 0.8$.

Table 1 shows the numerical data and condition correspondence values of the optical system shown in Fig. 4. Leftmost numbers represent the order from the object O side (or the primary image side) to the first concave reflecting-mirror $M_1$ (the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 1, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to the optical axis AX of the first imaging optical system $K_1$); $D_2$, the distance from the vertex of the rectangular prism $P_1$ to the vertex of the positive meniscus lens $L_{1P1}$ on the rectangular prism $P_1$ side; $D_{OI}$, the distance from the object surface O (mask) to the image surface I (primary image surface); $\Phi$max, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_1$ side of the negative meniscus lens; and $L_{GP-GN}$, the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 1

| First Embodiment | | | | | |
|---|---|---|---|---|---|
| WD = 2.33 | | | | | |
| $D_1$ = 2.06 | | | | | |
| $D_2$ = 0.27 | | | | | |
| $D_{OI}$ = 4.12 | | | | | |
| TL = 9.66 | | | | | |
| | r | d | n | Φ | Optical Member |
| 0 | | 2.33 | 1.00000 | | |
| 1 | -11.87 | 0.38 | 1.60384 | 2.7 | $L_{1P1}$ ($L_{2P1}$) |
| 2 | -5.42 | 0.05 | 1.00000 | | |
| 3 | -85.84 | 0.55 | 1.50332 | 2.7 | $L_{1P2}$ ($L_{2P2}$) |
| 4 | -3.00 | 0.08 | 1.00000 | | |
| 5 | -2.94 | 0.33 | 1.60384 | 2.7 | $L_{1P3}$ ($L_{2P3}$) |
| 6 | -18.79 | 0.05 | 1.00000 | | |
| 7 | 6.80 | 0.44 | 1.50332 | 2.7 | $L_{1P4}$ ($L_{2P4}$) |
| 8 | -10.44 | 3.77 | 1.00000 | | |
| 9 | 7.63 | 0.33 | 1.52670 | 1.7 | $L_{1N1}$ ($L_{2N1}$) |
| 10 | 5.47 | 1.35 | 1.00000 | | |
| 11 | -9.94 | | -1.00000 | 1.3 | $M_1$ ($M_2$) |

Condition Correspondence Values

(1) $2(WD - D_2)/\Phi max$ = 1.53
(2) $| f_{GN}/f_{GP}|$ = 6.55
(3) q = -6.06
(4) $L_{NM}/TL$ = 0.0795
(5) $L_{GP-GN}/TL$ = 0.529
(6) $| r_M/TL|$ = 1.03
(7) $f_{GP}/TL$ = 0.613

In Table 1, an image height Y is 1.0, and a numerical aperture N.A on the image side is 0.1. The 0th surface corresponds to the object surface or the image surface.

The optical system shown in Table 1 satisfies relation (1) so that a sufficient working distance is ensured.

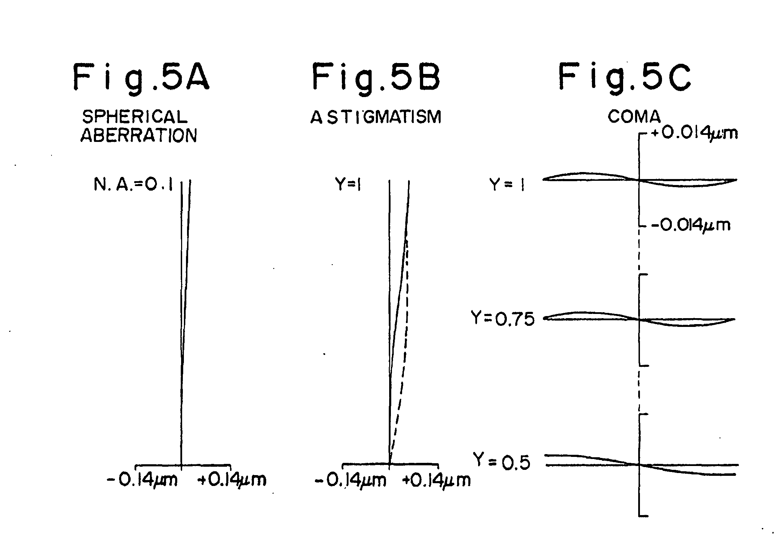

Figs. 5A, 5B and 5C show various aberrations caused by the light beam with an exposure wavelength (g-line: 436 nm) of the embodiment shown in Fig. 4. Comas shown in Fig. 5C are represented by aberration curves at image heights of 1, 0.75, and 0.5. The scale of a coma at each image height is ±0.014 μm. As is apparent from various aberrations shown in Figs. 5A, 5B and 5C, the various aberrations are corrected in a good balance.

The embodiment shown in Fig. 4 can be regarded as an advanced Dyson optical system. As a comparative example for the embodiment shown in Fig. 4, a Dyson optical system having a thick-walled plano-convex lens $L_P$ and a concave reflecting mirror M.

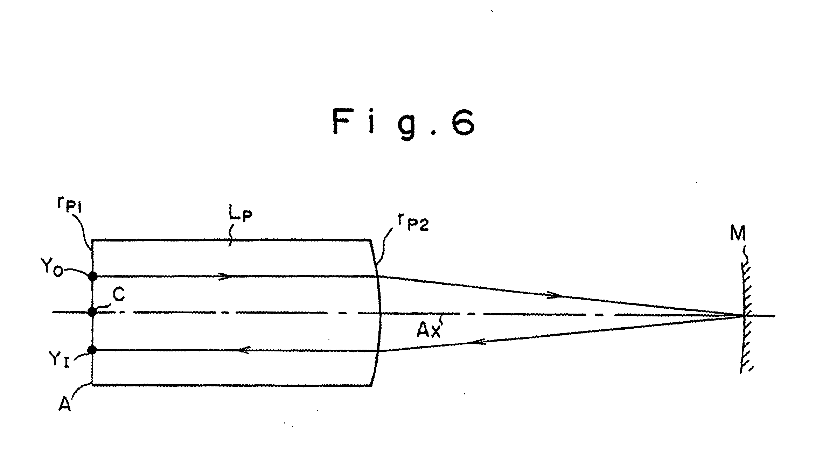

As shown in Fig. 6, the plano-convex lens $L_P$ is arranged such that a plane $r_{P1}$ matches an object surface A (object plane), and a center of curvature C of a lens surface $r_{P2}$ of the plano-convex lens $L_P$ matches the intersection of the object surface A and the optical axis AX of the Dyson optical system. The concave reflecting mirror M is arranged at the rear focal position of the plano-convex lens $L_P$ such that the center of curvature of the reflecting surface of the concave reflecting mirror M matches the center of curvature C of the lens surface $r_{P2}$ of the plano-convex lens $L_P$.

With this arrangement, as shown in Fig. 6, a light beam almost parallel to the optical axis AX and incident from an object point $Y_0$ on the object surface A on the plano-convex lens $L_P$ is refracted by the refracting surface $r_{P2}$ of the plano-convex lens $L_P$ and reaches the concave reflecting mirror M. The light beam reflected by the concave reflecting mirror M is refracted by the refracting surface $r_{P2}$ of the plano-convex lens $L_P$ again to become almost parallel to the optical axis AX, and reaches an image point $Y_I$ on the object surface A. The image of the object point $Y_0$ is formed at this image point $Y_I$.

Table 2 shows the numerical data of the Dyson optical system shown in Fig. 6, which has almost the same performance as that of the optical system of this embodiment shown in Table 1. Leftmost numbers represent the order from the object O side to the concave reflecting mirror M; r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material).

Table 2

|   | r | d | n | $\Phi$ | Optical Member |
|---|---|---|---|---|---|
| 0 |   | 0 | 1.60384 |   |   |
| 1 | $\infty$ | 21.92 | 1.60384 | 4.8 | $L_P$ |
| 2 | -21.92 | 36.30 | 1.00000 |   |   |
| 3 | 58.22 |   | -1.00000 | 7.4 | M |

When the distance from the object surface (object plane) or the image surface (image plane) to the concave reflecting mirror is the total length TL of the optical system, the total length TL of the first and second imaging optical systems ($K_1$ and $K_2$) of this embodiment shown in Fig. 1 is 9.66, and the total length TL of the Dyson optical system shown in Table 2 is 58.22. The total length of the Dyson optical system in Fig. 6 is as large as about six times that of the first and second imaging optical systems ($K_1$ and $K_2$) of this embodiment shown in Fig. 4. The outer diameters of the plano-convex lens $L_P$ and the concave reflecting mirror M in the Dyson optical system largely increase accordingly.

In the Dyson optical system shown in Fig. 6, therefore, when the projection optical system is constituted by combining the two optical systems, the size and manufacturing cost of the apparatus inconveniently increase.

In the Dyson optical system shown in Fig. 6, the object surface (object plane) and the image surface (image plane) match the plane $r_{P1}$ of the plano-convex lens $L_P$. For this reason, even when, e.g., a mask is set on the object surface (object plane), and, e.g., a plate is set on the image surface (image plane), scanning exposure can hardly be performed.

The plano-convex lens $L_P$ in the Dyson optical system shown in Fig. 6 can be made thin to obtain the working distance WD corresponding to the air conversion length. However, in this technique, a large spherical aberration and a large chromatic aberration are generated. It is difficult to sufficiently correct these aberrations because of the degree of freedom of aberration correction. Therefore, in the Dyson optical system shown in Fig. 6, no sufficient working distance can be ensured.

To the contrary, in this embodiment shown in Fig. 4, to sufficiently decrease the total length TL of the first and second imaging optical systems ($K_1$ and $K_2$) (the total length of the projection optical system), the radii of curvature of the concave reflecting mirrors ($M_1$ and $M_2$) are decreased. A light beam incident from a position higher than the optical axis on the first positive lens group $G_{1P}$ or the second positive lens group $G_{2P}$ must be largely refracted by the first positive lens group $G_{1P}$ or the second positive lens group $G_{2P}$, so various large aberrations are generated. To ensure the degree of freedom of aberration correction, each of the first positive lens group $G_{1P}$ and the second positive lens group $G_{2P}$ is constituted by about four lenses. To achieve size reduction of the optical system, each of the first positive lens group $G_{1P}$ and the second positive lens group $G_{2P}$ is preferably constituted by about three to seven lenses.

In the first or second imaging optical system ($K_1$ or $K_2$) of this embodiment shown in Fig. 4, an excessively corrected spherical aberration tends to be generated in the first positive lens group $G_{1P}$ or the second positive lens group $G_{2P}$. In this embodiment, to satisfactorily correct the excessively corrected spherical aberration, the first negative lens group $G_{1N}$ (or the second negative lens group $G_{2N}$) having a negative refracting power is arranged in the optical path between the first positive lens group $G_{1P}$ (or the second positive lens group $G_{2P}$) and the first concave reflecting mirror $M_1$ (or the second concave reflecting mirror $M_2$). Particularly, to obtain the effective function of the first negative lens group $G_{1N}$ (or the second negative lens group $G_{2N}$) to correct the excessively corrected spherical aberration generated in the first positive lens group $G_{1P}$ (or the second positive lens group $G_{2P}$), a negative meniscus lens arranged at a position closer to the first concave reflecting mirror $M_1$ (or the second concave reflecting mirror $M_2$) is preferably included. In the first or second imaging optical system ($K_1$ or $K_2$) of this embodiment shown in Fig. 4 as well, the first negative lens group $G_{1N}$ (or the second negative lens group $G_{2N}$) has an arrangement including a negative meniscus lens arranged at a position closer to the first concave reflecting mirror $M_1$ (or the second concave reflecting mirror $M_2$).

As described above, according to the first and second imaging optical systems ($K_1$ and $K_2$) of this embodiment shown in Fig. 4, a compact projection optical system having excellent imaging performance can be realized at a low cost while ensuring the sufficient working distance WD. Therefore, a relatively compact and high-performance scanning exposure apparatus capable of performing an exposure operation in a large exposure area can be obtained.

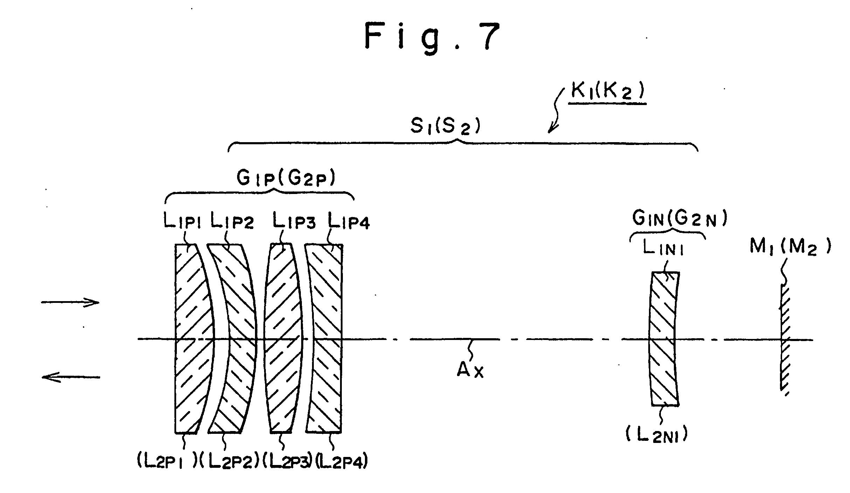

An example of the first and second imaging optical systems ($K_1$ and $K_2$) has been described above with reference to Fig. 4. A projection optical system according to the second embodiment will be described below with reference to Fig. 7.

Fig. 7 is a view showing the lens arrangement of a first imaging optical system $K_1$ (or a second imaging optical system $K_2$) shown in Fig. 1 according to the second embodiment. For the descriptive convenience, the lens arrangement shown in Fig. 7 will be described as that of the first imaging optical system $K_1$.

As shown in Fig. 7, the first imaging optical system $K_1$ (or the second imaging optical system $K_2$) has a first refraction optical system $S_1$ (or a second refraction optical system $S_2$) consisting of a first positive lens group $G_{1P}$ (or a second positive lens group $G_{2P}$) and a first negative lens group $G_{1N}$ (or a second negative lens group $G_{2N}$), and a first concave reflecting mirror $M_1$ (or a second concave reflecting mirror $M_2$). For the descriptive convenience, in Fig. 7, a first rectangular prism $P_1$ (or a second rectangular prism $P_2$) arranged on the left side of the first refraction optical system $S_1$ (or the second refraction optical system $S_2$) is not illustrated.

As shown in Fig. 7, the first positive lens group $G_{1P}$ (or the second positive lens group $G_{2P}$) comprises a positive lens $L_{1P1}$ having its surface with a larger curvature facing the first concave reflecting mirror $M_1$ side (or a positive lens $L_{2P1}$ having its surface with a larger curvature facing the second concave reflecting mirror $M_2$ side), a negative meniscus lens $L_{1P2}$ having its convex surface facing the first concave reflecting mirror $M_1$ side (or a negative meniscus lens $L_{2P2}$ having its convex surface facing the second concave reflecting mirror $M_2$ side), a biconvex positive lens $L_{1P3}$ (or a biconvex positive lens $L_{2P3}$), and a negative lens $L_{1P4}$ (or a negative lens $L_{2P4}$). The first negative lens group $G_{1N}$ (or the second negative lens group $G_{2N}$) comprises only a negative meniscus lens $L_{1N1}$ having its convex surface facing the first positive lens group $G_{1P}$ side (or a negative meniscus lens $L_{2N1}$ having its convex surface facing the second positive lens group $G_{2P}$ side).

Table 3 shows the numerical data of the optical system shown in Fig. 7. Leftmost numbers represent the order from an object O side (or the primary image side) to the first concave reflecting mirror $M_1$ (or the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 3, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); $\Phi$max, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_1$ side of the negative meniscus lens; and $L_{GP\text{-}GN}$, the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 3

| Second Embodiment | | | | | |
|---|---|---|---|---|---|
| WD = 2.33 | | | | | |
| $D_1$ = 2.06 | | | | | |
| $D_2$ = 0.27 | | | | | |
| $D_{OI}$ = 4.12 | | | | | |
| TL = 10.55 | | | | | |
| | r | d | n | $\Phi$ | Optical Member |
| 0 | | 2.33 | 1.00000 | | |
| 1 | 230.38 | 0.58 | 1.50332 | 2.7 | $L_{1P1}$ ($L_{2P1}$) |
| 2 | -3.66 | 0.11 | 1.00000 | | |
| 3 | -2.93 | 0.38 | 1.60384 | 2.7 | $L_{1P2}$ ($L_{2P2}$) |
| 4 | -4.40 | 0.05 | 1.00000 | | |

Table 3   (continued)

| Second Embodiment | | | | | |
|---|---|---|---|---|---|
| | r | d | n | Φ | Optical Member |
| 5 | 12.74 | 0.55 | 1.50332 | 2.7 | $L_{1P3}$ ($L_{2P3}$) |
| 6 | -5.27 | 0.05 | 1.00000 | | |
| 7 | -8.29 | 0.38 | 1.60384 | 2.7 | $L_{1P4}$ ($L_{2P4}$) |
| 8 | -41.15 | 4.25 | 1.00000 | | |
| 9 | 11.17 | 0.33 | 1.52670 | 1.8 | $L_{1N1}$ ($L_{2N1}$) |
| 10 | 8.23 | 1.53 | 1.00000 | | |
| 11 | -10.78 | | -1.00000 | 1.6 | $M_1$ ($M_2$) |

Condition Correspondence Values of Second Embodiment

(1) $2(WD - D_2)/\Phi max = 1.53$
(2) $|f_{GN}/f_{GP}| = 9.19$
(3) $q = -6.06$
(4) $L_{NM}/TL = 0.0860$
(5) $L_{GP-GN}/TL = 0.551$
(6) $|r_M/TL| = 1.02$
(7) $f_{GP}/TL = 0.636$

In Table 3, an image height Y is 1.0, and a numerical aperture N.A on the image side is 0.1. The 0th surface corresponds to the object surface or the image surface.

The optical system shown in Table 3 satisfies relation (1) so that a sufficient working distance is ensured.

The total length TL of the first and second imaging optical systems ($K_1$ and $K_2$) of the embodiment shown in Table 3 is 10.54, and the total length TL of the Dyson optical system shown in Table 2 is 58.22. Therefore, the total length of the embodiment shown in Table 3 is as small as about 1/6 that of the Dyson optical system in Fig. 6.

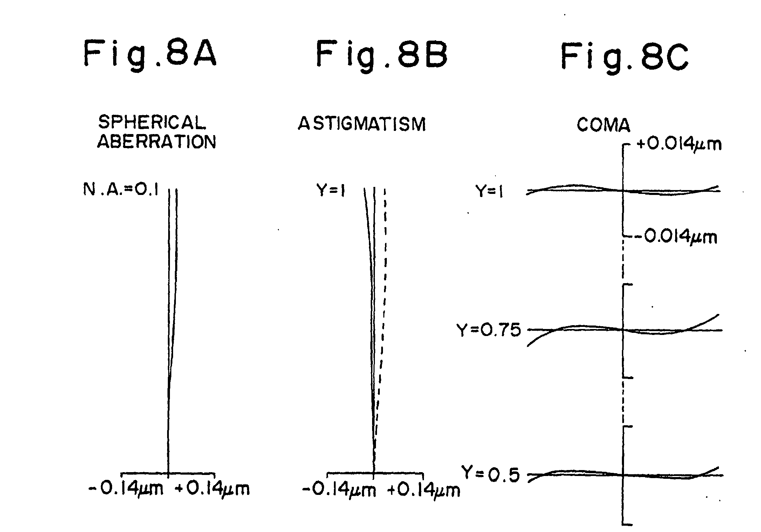

Figs. 8A, 8B and 8C show various aberrations caused by the light beam with an exposure wavelength (g-line: 436 nm) of the embodiment shown in Fig. 7. Comas shown in Fig. 8C are represented by aberration curves at image heights of 1, 0.75, and 0.5. The scale of a coma at each image height is $\pm 0.014$ μm. As is apparent from various aberrations shown in Figs. 8A, 8B and 8C, the various aberrations are corrected in a good balance.

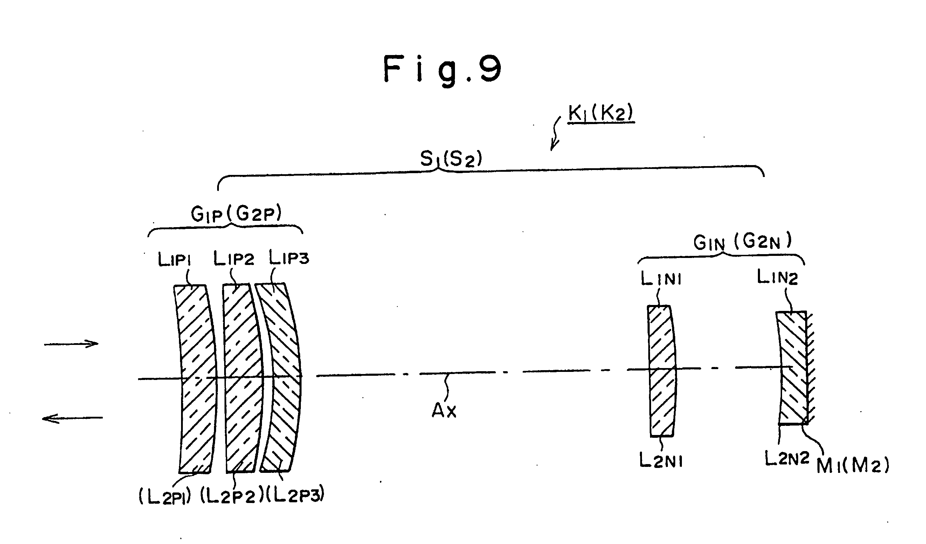

A first imaging optical system $K_1$ (or a second imaging optical system $K_2$) constituting a projection optical system according to the third embodiment will be described below with reference to Fig. 9.

Fig. 9 is a view showing the lens arrangement of the first imaging optical system $K_1$ (or the second imaging optical system $K_2$) shown in Fig. 1 according to the third embodiment. For the descriptive convenience, the lens arrangement shown in Fig. 9 will be described as that of the first imaging optical system $K_1$.

As shown in Fig. 9, the first imaging optical system $K_1$ (or the second imaging optical system $K_2$) has a first refraction optical system $S_1$ (or a second refraction optical system $S_2$) consisting of a first positive lens group $G_{1P}$ (or a second positive lens group $G_{2P}$) and a first negative lens group $G_{1N}$ (or a second negative lens group $G_{2N}$), and a first concave reflecting mirror $M_1$ (or a second concave reflecting mirror $M_2$). For the descriptive convenience, in Fig. 9, a first rectangular prism $P_1$ (or a second rectangular prism $P_2$) arranged on the left side of the first refraction optical system $S_1$ (or the second refraction optical system $S_2$) is not illustrated.

As shown in Fig. 9, the first positive lens group $G_{1P}$ (or the second positive lens group $G_{2P}$) comprises a positive meniscus lens $L_{1P1}$ having its convex surface facing the first concave reflecting mirror $M_1$ side (or a positive meniscus lens $L_{2P1}$ having its convex surface facing the second concave reflecting mirror $M_2$ side), a positive meniscus lens $L_{1P2}$ having its convex surface facing the first concave reflecting mirror $M_1$ side (or a positive meniscus lens $L_{2P2}$ having its convex surface facing the second concave reflecting mirror $M_2$ side), and a negative meniscus lens $L_{1P3}$ having its convex surface facing the first concave reflecting mirror $M_1$ side (or a negative meniscus lens $L_{2P3}$ having its convex surface facing the second concave reflecting mirror $M_2$ side). The first negative lens group $G_{1N}$ (or the second negative lens group $G_{2N}$) comprises a biconvex positive lens $L_{1N1}$ (or a biconvex positive lens $L_{2N1}$), and a negative meniscus lens $L_{1N2}$ bonded to the first concave reflecting mirror $M_1$ and having its concave surface facing the first positive lens group $G_{1P}$ side (or a negative meniscus lens $L_{2N2}$ bonded to the second concave reflecting mirror $M_2$ and having its concave surface facing the second positive lens group $G_{2P}$ side).

Table 4 shows the numerical data of the optical system shown in Fig. 9. Leftmost numbers represent the order from an object O side (or the primary image side) to the first concave reflecting mirror $M_1$ (or the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 4, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); $\Phi$max, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); and $L_{GP-GN}$, the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 4

| Third Embodiment | | | | | |
|---|---|---|---|---|---|
| WD = 2.11 | | | | | |
| $D_1$ = 1.84 | | | | | |
| $D_2$ = 0.27 | | | | | |
| $D_{OI}$ = 3.68 | | | | | |
| TL = 12.26 | | | | | |
| | r | d | n | $\Phi$ | Optical Member |
| 0 | | 2.11 | 1.00000 | | |
| 1 | -14.36 | 0.49 | 1.60384 | 2.7 | $L_{1P1}$ ($L_{2P1}$) |
| 2 | -6.93 | 0.05 | 1.00000 | | |
| 3 | -23.94 | 0.49 | 1.50332 | 2.7 | $L_{1P2}$ ($L_{2P2}$) |
| 4 | -4.34 | 0.11 | 1.00000 | | |
| 5 | -3.72 | 0.41 | 1.59593 | 2.7 | $L_{1P3}$ ($L_{2P3}$) |
| 6 | -4.84 | 5.39 | 1.00000 | | |
| 7 | 244.04 | 0.41 | 1.50332 | 2.3 | $L_{1N1}$ ($L_{2N1}$) |
| 8 | -6.26 | 2.47 | 1.00000 | | |
| 9 | -4.83 | 0.33 | 1.52670 | 1.6 | $L_{1N2}$ ($L_{2N2}$) |
| 10 | -12.71 | | 1.00000 | 1.6 | $M_1$ ($M_2$) |

Condition Correspondence Values of Third Embodiment

    (1) 2(WD - $D_2$)/$\Phi$max = 1.36
    (2) | $f_{GN}/f_{GP}$| = 24.2
    (5) $L_{GP-GN}$/TL = 6.51
    (6) | $r_M$/TL| = 1.04
    (7) $f_{GP}$/TL = 0.777

In Table 4, an image height Y is 1.0, and a numerical aperture N.A on the image side is 0.1. The 0th surface corresponds to the object surface or the image surface.

The optical system shown in Table 4 satisfies relation (1) so that a sufficient working distance is ensured.

The total length TL of the first and second imaging optical systems ($K_1$ and $K_2$) of the embodiment shown in Table 4 is 12.26, and the total length TL of the Dyson optical system shown in Table 2 is 58.22. Therefore, the total length of the embodiment shown in Table 4 is as small as about 1/5 that of the Dyson optical system in Fig. 6.

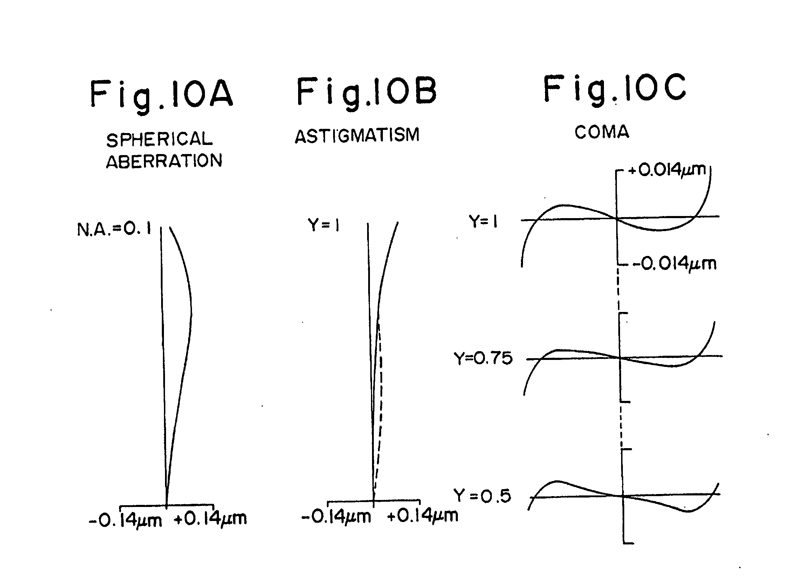

Figs. 10A, 10B and 10C show various aberrations caused by the light beam with an exposure wavelength (g-line: 436 nm) of the embodiment shown in Fig. 9. Comas shown in Fig. 10C are represented by aberration curves at image heights of 1, 0.75, and 0.5. The scale of a coma at each image height is ±0.014 µm. As is apparent from various aberrations shown in Figs. 10A, 10B and 10C, the various aberrations are corrected in a good balance.

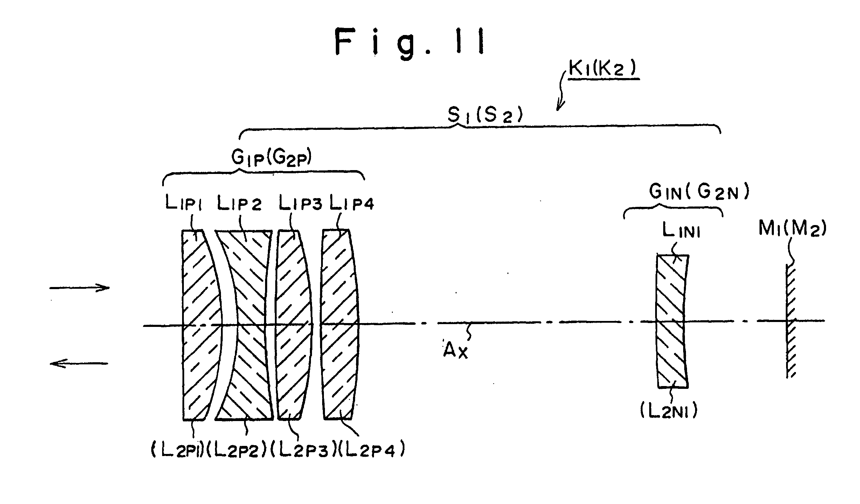

A first imaging optical system $K_1$ (or a second imaging optical system $K_2$) constituting a projection optical system according to the fourth embodiment will be described below with reference to Fig. 11.

Fig. 11 is a view showing the lens arrangement of the first imaging optical system $K_1$ (or the second imaging optical system $K_2$) shown in Fig. 1 according to the fourth embodiment. For the descriptive convenience, the lens arrangement shown in Fig. 11 will be described as that of the first imaging optical system $K_1$.

As shown in Fig. 11, the first imaging optical system $K_1$ (or the second imaging optical system $K_2$) has a first refraction optical system $S_1$ (or a second refraction optical system $S_2$) consisting of a first positive lens group $G_{1P}$ (or a second positive lens group $G_{2P}$) and a first negative lens group $G_{1N}$ (or a second negative lens group $G_{2N}$), and a first concave reflecting mirror $M_1$ (or a second concave reflecting mirror $M_2$). For the descriptive convenience, in Fig. 11, a first rectangular prism $P_1$ (or a second rectangular prism $P_2$) arranged on the left side of the first refraction optical system $S_1$ (or the second refraction optical system $S_2$) is not illustrated.

As shown in Fig. 11, the first positive lens group $G_{1P}$ (or the second positive lens group $G_{2P}$) comprises a positive lens $L_{1P1}$ having its surface with a larger curvature facing the first concave reflecting mirror $M_1$ side (or a positive lens $L_{2P1}$ having its surface with a larger curvature facing the second concave reflecting mirror $M_2$ side), a biconcave negative lens $L_{1P2}$ (or a biconcave negative lens $L_{2P2}$), a biconvex positive lens $L_{1P3}$ (or a biconvex positive lens $L_{2P3}$), and a biconcave positive lens $L_{1P4}$ (or a biconcave positive lens $L_{2P4}$). The first negative lens group $G_{1N}$ (or the second negative lens group $G_{2N}$) comprises a negative meniscus lens $L_{1N1}$ having its convex surface facing the first positive lens group $G_{1P}$ side (or a negative meniscus lens $L_{2N1}$ having its convex surface facing the second positive lens group $G_{2P}$ side).

Table 5 shows the numerical data of the optical system shown in Fig. 11. Leftmost numbers represent the order from an object O side (or the primary image side) to the first concave reflecting mirror $M_1$ (or the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and Φ, the outer diameter of a medium (optical material). In Table 5, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); Φmax, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_1$ side of the negative meniscus lens; and $L_{GP-GN}$, the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 5

| Fourth Embodiment | | | | | |
|---|---|---|---|---|---|
| WD = 2.14 | | | | | |
| $D_1$ = 1.87 | | | | | |
| $D_2$ = 0.27 | | | | | |
| $D_{OI}$ = 3.74 | | | | | |
| TL = 11.06 | | | | | |
| | r | d | n | Φ | Optical Member |
| 0 | | 2.14 | 1.00000 | | |
| 1 | 27.29 | 0.52 | 1.50332 | 2.8 | $L_{1P1}$ ($L_{2P1}$) |

Table 5   (continued)

| Fourth Embodiment | | | | | |
|---|---|---|---|---|---|
| | r | d | n | Φ | Optical Member |
| 2 | -2.91 | 0.05 | 1.00000 | | |
| 3 | -2.82 | 0.33 | 1.60384 | 2.8 | $L_{1P2}$ ($L_{2P2}$) |
| 4 | 7.51 | 0.08 | 1.00000 | | |
| 5 | 7.26 | 0.55 | 1.50332 | 2.8 | $L_{1P3}$ ($L_{2P3}$) |
| 6 | -7.27 | 0.05 | 1.00000 | | |
| 7 | 24.14 | 0.47 | 1.60384 | 2.8 | $L_{1P4}$ ($L_{2P4}$) |
| 8 | -7.46 | 5.40 | 1.00000 | | |
| 9 | 15.84 | 0.33 | 1.52670 | 1.8 | $L_{1N2}$ ($L_{2N2}$) |
| 10 | 10.07 | 1.14 | 1.00000 | | |
| 11 | -11.18 | | -1.00000 | 1.5 | $M_1$ ($M_2$) |

Condition Correspondence Values of Fourth Embodiment

(1) $2(WD - D_2)/\Phi max = 1.34$
(2) $| f_{GN}/f_{GP}| = 7.68$
(3) $q = -4.49$
(4) $L_{NM}/TL = 0.0688$
(5) $L_{GP-GN}/TL = 0.561$
(6) $| r_M/TL| = 1.01$
(7) $f_{GP}/TL = 0.629$

In Table 5, an image height Y is 1.0, and a numerical aperture N.A on the image side is 0.1. The 0th surface corresponds to the object surface or the image surface.

The optical system shown in Table 5 satisfies relation (1) so that a sufficient working distance is ensured.

The total length TL of the first and second imaging optical systems ($K_1$ and $K_2$) of the embodiment shown in Table 5 is 11.06, and the total length TL of the Dyson optical system shown in Table 2 is 58.22. Therefore, the total length of the embodiment shown in Table 5 is as small as about 1/5 that of the Dyson optical system in Fig. 6.

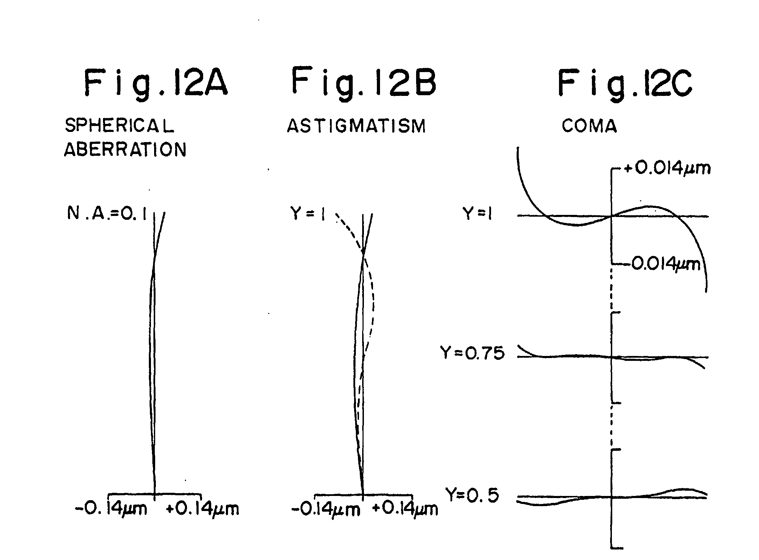

Figs. 12A, 12B and 12C show various aberrations caused by the light beam with an exposure wavelength (g-line: 436 nm) of the embodiment shown in Fig. 11. Comas shown in Fig. 12C are represented by aberration curves at image heights of 1, 0.75, and 0.5. The scale of a coma at each image height is ±0.014 μm. As is apparent from various aberrations shown in Figs. 12A, 12B and 12C, the various aberrations are corrected in a good balance.

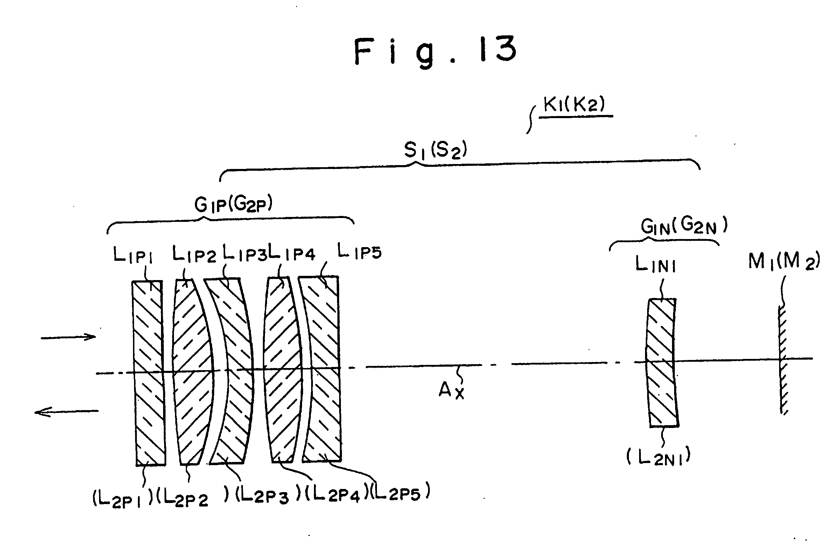

A first imaging optical system $K_1$ (or a second imaging optical system $K_2$) according to the fifth embodiment will be described below with reference to Fig. 13.

Fig. 13 is a view showing the lens arrangement of the first imaging optical system $K_1$ (the a second imaging optical system $K_2$) shown in Fig. 1 according to the fifth embodiment. For the descriptive convenience, the lens arrangement shown in Fig. 13 will be described as that of the first imaging optical system $K_1$.

As shown in Fig. 13, the first imaging optical system $K_1$ (or the second imaging optical system $K_2$) has a first refraction optical system $S_1$ (or a second refraction optical system $S_2$) consisting of a first positive lens group $G_{1P}$ (or a second positive lens group $G_{2P}$) and a first negative lens group $G_{1N}$ (or a second negative lens group $G_{2N}$), and a first concave reflecting mirror $M_1$ (or a second concave reflecting mirror $M_2$). For the descriptive convenience, in Fig. 13, a first rectangular prism $P_1$ (or a second rectangular prism $P_2$) arranged on the left side of the first refraction optical system $S_1$ (or the second refraction optical system $S_2$) is not illustrated.

As shown in Fig. 13, the first positive lens group $G_{1P}$ (or the second positive lens group $G_{2P}$) comprises a biconcave negative lens $L_{1P1}$ having a weak refracting power (or a biconcave negative lens $L_{2P1}$ having a weak refracting power), a biconvex positive lens $L_{1P2}$ (or a biconvex positive lens $L_{2P2}$), a negative meniscus lens $L_{1P3}$ having its convex surface facing the first concave reflecting mirror $M_1$ side (or a negative meniscus lens $L_{2P3}$ having its convex surface facing the second concave reflecting mirror $M_2$), a biconvex positive lens $L_{1P4}$ (or a biconvex positive lens $L_{2P4}$), and a negative lens $L_{1P5}$ having its surface with a larger curvature facing the biconvex positive lens $L_{1P4}$ side (or a negative lens $L_{2P5}$ having its surface with a larger curvature facing the biconvex positive lens $L_{2P4}$ side). The first negative lens group $G_{1N}$ (or the second negative lens group $G_{2N}$) comprises a negative meniscus lens $L_{1N1}$ having its

**15**

convex surface facing the first positive lens group $G_{1P}$ side (or a negative meniscus lens $L_{2N1}$ having its convex surface facing the second positive lens group $G_{2P}$ side).

Table 6 shows the numerical data of the optical system shown in Fig. 13. Leftmost numbers represent the order from an object O side (or the primary image side) to the first concave reflecting mirror $M_1$ (or the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 6, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); $\Phi$max, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_1$ side of the negative meniscus lens; and $L_{GP-GN}$, the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 6

| Fifth Embodiment | | | | | |
|---|---|---|---|---|---|
| WD = 2.05 | | | | | |
| $D_1$ = 1.78 | | | | | |
| $D_2$ = 0.27 | | | | | |
| $D_{OI}$ = 3.56 | | | | | |
| TL = 10.59 | | | | | |
| | r | d | n | $\Phi$ | Optical Member |
| 0 | | 2.05 | 1.00000 | | |
| 1 | -65.99 | 0.41 | 1.60384 | 3.1 | $L_{1P1}$ ($L_{2P1}$) |
| 2 | 25.92 | 0.05 | 1.00000 | | |
| 3 | 12.47 | 0.55 | 1.50332 | 3.1 | $L_{1P2}$ ($L_{2P2}$) |
| 4 | -4.06 | 0.11 | 1.00000 | | |
| 5 | -3.24 | 0.41 | 1.52670 | 3.1 | $L_{1P3}$ ($L_{2P3}$) |
| 6 | -5.31 | 0.05 | 1.00000 | | |
| 7 | 27.75 | 0.55 | 1.50332 | 3.1 | $L_{1P4}$ ($L_{2P4}$) |
| 8 | -4.33 | 0.08 | 1.00000 | | |
| 9 | -4.41 | 0.41 | 1.52670 | 3.1 | $L_{1P5}$ ($L_{2P5}$) |
| 10 | -7.07 | 3.91 | 1.00000 | | |
| 11 | 15.06 | 0.41 | 1.52670 | 2.4 | $L_{1N1}$ ($L_{2N1}$) |
| 12 | 9.05 | 1.60 | 1.00000 | | |
| 13 | -10.79 | | -1.00000 | 2.1 | $M_1$ ($M_2$) |

Condition Correspondence Values of Fifth Embodiment

(1) 2(WD - $D_2$)/$\Phi$max = 1.15
(2) | $f_{GN}/f_{GP}$| = 6.88

(3) q = -4.00
(4) $L_{NM}/TL = 0.112$
(5) $L_{GP-GN}/TL = 0.497$
(6) $| r_M/TL| = 1.02$
(7) $f_{GP}/TL = 0.605$

In Table 6, an image height Y is 1.0, and a numerical aperture N.A on the image side is 0.15. The 0th surface corresponds to the object surface or the image surface.

The optical system shown in Table 6 satisfies relation (1) so that a sufficient working distance is ensured.

The total length TL of the first and second imaging optical systems ($K_1$ and $K_2$) of the embodiment shown in Table 6 is 10.59, and the total length TL of the Dyson optical system shown in Table 2 is 58.22. Therefore, the total length of the embodiment shown in Table 6 is as small as about 1/5 that of the Dyson optical system in Fig. 6.

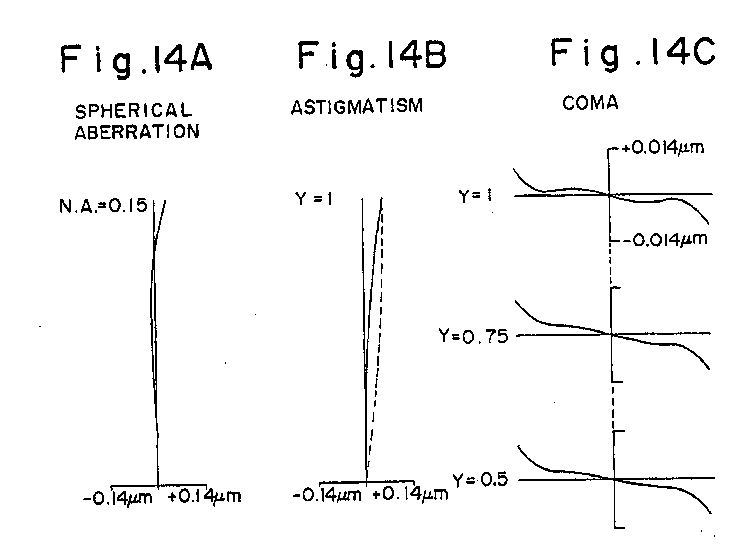

Figs. 14A, 14B and 14C show various aberrations caused by the light beam with an exposure wavelength (g-line: 436 nm) of the embodiment shown in Fig. 13. Comas shown in Fig. 14C are represented by aberration curves at image heights of 1, 0.75, and 0.5. The scale of a coma at each image height is ±0.014 µm. As is apparent from various aberrations shown in Figs. 14A, 14B and 14C, the various aberrations are corrected in a good balance.

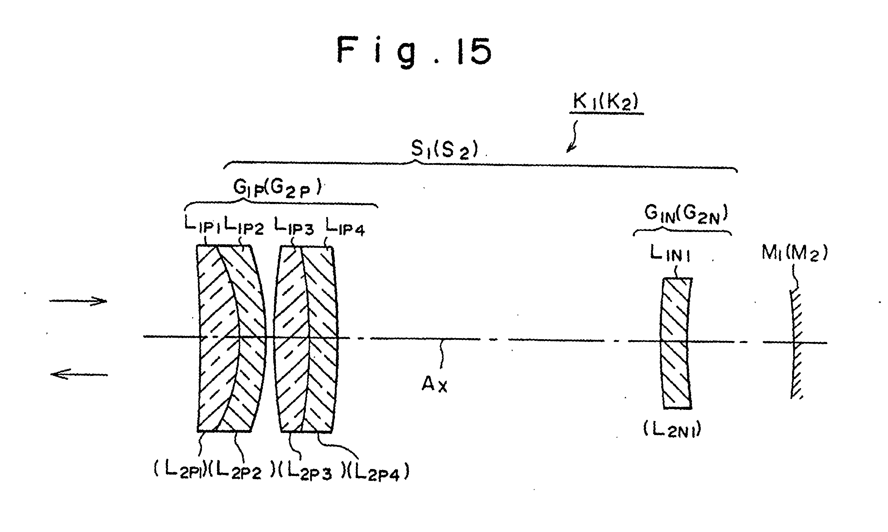

A first imaging optical system $K_1$ (or a second imaging optical system $K_2$) constituting a projection optical system according to the sixth embodiment will be described below with reference to Fig. 15.

Fig. 15 is a view showing the lens arrangement of the first imaging optical system $K_1$ (the a second imaging optical system $K_2$) shown in Fig. 1 according to the sixth embodiment. For the descriptive convenience, the lens arrangement shown in Fig. 15 will be described as that of the first imaging optical system $K_1$.

As shown in Fig. 15, the first imaging optical system $K_1$ (or the second imaging optical system $K_2$) has a first refraction optical system $S_1$ (or a second refraction optical system $S_2$) consisting of a first positive lens group $G_{1P}$ (or a second positive lens group $G_{2P}$) and a first negative lens group $G_{1N}$ (or a second negative lens group $G_{2N}$), and a first concave reflecting mirror $M_1$ (or a second concave reflecting mirror $M_2$). For the descriptive convenience, in Fig. 15, a first rectangular prism $P_1$ (or a second rectangular prism $P_2$) arranged on the left side of the first refraction optical system $S_1$ (or the second refraction optical system $S_2$) is not illustrated.

As shown in Fig. 15, the first positive lens group $G_{1P}$ comprises a positive meniscus lens $L_{1P1}$ having its convex surface facing the first concave reflecting mirror $M_1$ side, a negative meniscus lens $L_{1P2}$ bonded to the positive meniscus lens $L_{1P1}$ and having its convex surface facing the first concave reflecting mirror $M_1$ side, a biconvex positive lens $L_{1P3}$, and a negative meniscus lens $L_{1P4}$ bonded to the biconvex positive lens $L_{1P3}$ and having its convex surface facing the first concave reflecting mirror $M_1$ side, in this order from the object side to the first concave reflecting mirror $M_1$ side. The first negative lens group $G_{1N}$ comprises a negative meniscus lens $L_{1N1}$ having its convex surface facing the first positive lens group $G_{1P}$ side.

In this embodiment, since the first positive lens group $G_{1P}$ is constituted by a bonded lens component (a bonded lens component consisting of the positive meniscus lens $L_{1P1}$ and the negative meniscus lens $L_{1P2}$, or a bonded lens component consisting of the positive lens $L_{1P3}$ and the negative meniscus lens $L_{1P4}$), the number of components of the first positive lens group $G_{1P}$ itself is decreased. With this arrangement, a larger decentering tolerance can be set to the first positive lens group $G_{1P}$, and the projection optical system can be easily manufactured.

Table 7 shows the numerical data of the optical system shown in Fig. 15. Leftmost numbers represent the order from an object O side (or the primary image side) to the first concave reflecting mirror $M_1$ (or the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 7, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); $\Phi$max, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_1$ side of the negative meniscus lens; and $L_{GP-GN}$,

the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 7

| Sixth Embodiment | | | | | |
|---|---|---|---|---|---|
| WD = 2.29 | | | | | |
| $D_1$ = 2.02 | | | | | |
| $D_2$ = 0.27 | | | | | |
| $D_{OI}$ = 4.04 | | | | | |
| TL = 11.99 | | | | | |
| | r | d | n | Φ | Optical Member |
| 0 | | 2.29 | 1.00000 | | |
| 1 | -12.83 | 0.55 | 1.50332 | 2.9 | $L_{1P1}$ ($L_{2P1}$) |
| 2 | -2.24 | 0.38 | 1.60384 | 2.9 | $L_{1P2}$ ($L_{2P2}$) |
| 3 | -5.05 | 0.05 | 1.00000 | | |
| 4 | 10.57 | 0.55 | 1.50332 | 2.9 | $L_{1P3}$ ($L_{2P3}$) |
| 5 | -8.20 | 0.38 | 1.52670 | 2.9 | $L_{1P4}$ ($L_{2P4}$) |
| 6 | -12.32 | 4.81 | 1.00000 | | |
| 7 | 8.99 | 0.38 | 1.52670 | 2.2 | $L_{1N1}$ ($L_{2N1}$) |
| 8 | 7.56 | 2.60 | 1.00000 | | |
| 9 | -12.33 | | -1.00000 | 1.9 | $M_1$ ($M_2$) |

Condition Correspondence Values of Sixth Embodiment

    (1) $2(WD - D_2)/\Phi max$ = 1.39
    (2) $| f_{GN}/f_{GP}|$ = 12.6
    (3) q = -11.6
    (4) $L_{NM}/TL$ = 0.952
    (5) $L_{GP-GN}/TL$ = 0.568
    (6) $| r_M/TL|$ = 1.03
    (7) $f_{GP}/TL$ = 0.656

In Table 7, an image height Y is 1.0, and a numerical aperture N.A on the image side is 0.1. The 0th surface corresponds to the object surface or the image surface.

The optical system shown in Table 7 satisfies relation (1) so that a sufficient working distance is ensured.

The total length TL of the first and second imaging optical systems ($K_1$ and $K_2$) of the embodiment shown in Table 7 is 11.99, and the total length TL of the Dyson optical system shown in Table 2 is 58.22. Therefore, the total length of the embodiment shown in Table 7 is as small as about 1/5 that of the Dyson optical system in Fig. 6.

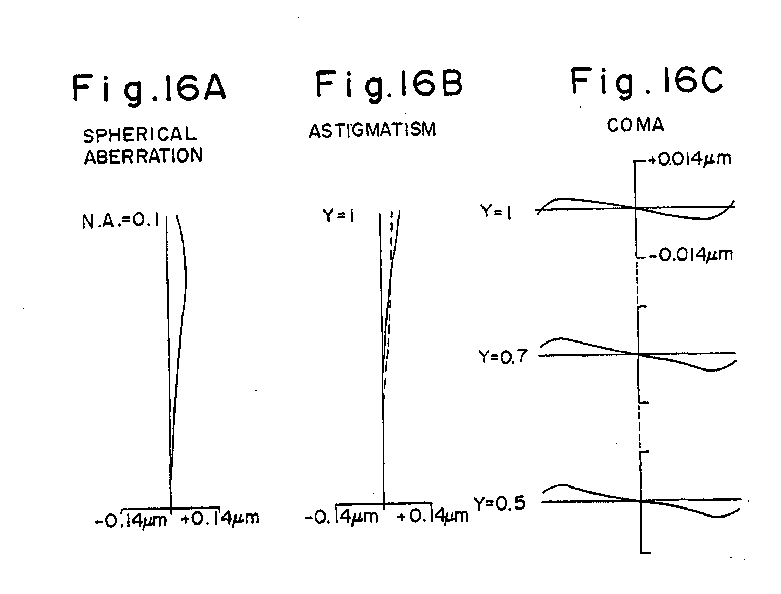

Figs. 16A, 16B and 16C show various aberrations caused by the light beam with an exposure wavelength (g-line: 436 nm) of the embodiment shown in Fig. 15. Comas shown in Fig. 16C are represented by aberration curves at image heights of 1, 0.75, and 0.5. The scale of a coma at each image height is ±0.014 µm. As is apparent from various aberrations shown in Figs. 16A, 16B and 16C, the various aberrations are corrected in a good balance.

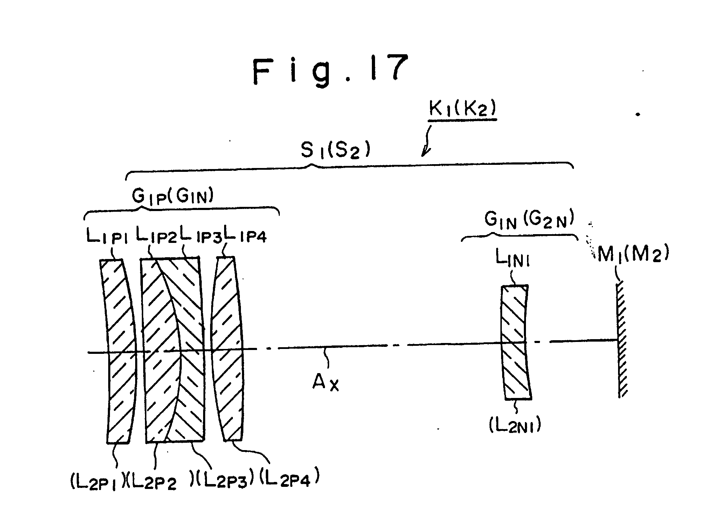

A first imaging optical system $K_1$ (or a second imaging optical system $K_2$) constituting a projection optical system according to the seventh embodiment will be described below with reference to Fig. 17.

Fig. 17 is a view showing the lens arrangement of the first imaging optical system $K_1$ (the a second imaging optical system $K_2$) shown in Fig. 1 according to the seventh embodiment. For the descriptive convenience, the lens arrangement shown in Fig. 17 will be described as that of the first imaging optical system $K_1$.

As shown in Fig. 17, the first imaging optical system $K_1$ (or the second imaging optical system $K_2$) has a first refraction optical system $S_1$ (or a second refraction optical system $S_2$) consisting of a first positive lens group $G_{1P}$ (or a second positive lens group $G_{2P}$) and a first negative lens group $G_{1N}$ (or a second negative lens group $G_{2N}$), and a first concave reflecting mirror $M_1$ (or a second concave reflecting mirror $M_2$). For the descriptive convenience, in Fig. 17, a first rectangular prism $P_1$ (or a second rectangular prism $P_2$) arranged on the left side of the first refraction optical

system $S_1$ (or the second refraction optical system $S_2$) is not illustrated.

As shown in Fig. 17, the first positive lens group $G_{1P}$ comprises a positive meniscus lens $L_{1P1}$ having its convex surface facing the first concave reflecting mirror $M_1$ side, a positive meniscus lens $L_{1P2}$ having its convex surface facing the first concave reflecting mirror $M_1$ side, a negative meniscus lens $L_{1P3}$ bonded to the positive meniscus lens $L_{1P2}$ and having its convex surface facing the first concave reflecting mirror $M_1$ side, and a biconvex positive lens $L_{1P4}$ having its surface with a larger curvature facing the negative meniscus lens $L_{1P3}$ side, in this order from the object side to the first concave reflecting mirror $M_1$ side. The first negative lens group $G_{1N}$ comprises a negative meniscus lens $L_{1N1}$ having its convex surface facing the first positive lens group $G_{1P}$ side.

In this embodiment, since the positive meniscus lens $L_{1P2}$ and the negative meniscus lens $L_{1P3}$ in the first positive lens group $G_{1P}$ are constituted as a bonded lens component, a larger decentering tolerance can be set to the two lenses, and the number of components of the first positive lens group $G_{1P}$ itself is decreased. With this arrangement, the projection optical system can be easily manufactured.

Table 8 shows the numerical data of the optical system shown in Fig. 17. Leftmost numbers represent the order from an object O side (or the primary image side) to the first concave reflecting mirror $M_1$ (or the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 8, WD represents the working distance of the first imaging optical system $K_1$; $D_1$, the distance from the object surface 0 to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); $\Phi$max, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_1$ side of the negative meniscus lens; and $L_{GP\text{-}GN}$, the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 8

| Seventh Embodiment | | | | | |
|---|---|---|---|---|---|
| WD = 2.29 | | | | | |
| $D_1$ = 2.02 | | | | | |
| $D_2$ = 0.27 | | | | | |
| $D_{OI}$ = 4.04 | | | | | |
| TL = 9.92 | | | | | |
| | r | d | n | $\Phi$ | Optical Member |
| 0 | | 2.29 | 1.00000 | | |
| 1 | -7.12 | 0.39 | 1.48088 | 2.8 | $L_{1P1}$ ($L_{2P1}$) |
| 2 | -4.33 | 0.04 | 1.00000 | | |
| 3 | -34.60 | 0.54 | 1.48088 | 2.8 | $L_{1P2}$ ($L_{2P2}$) |
| 4 | -2.62 | 0.35 | 1.60384 | 2.8 | $L_{1P3}$ ($L_{2P3}$) |
| 5 | -7.75 | 0.04 | 1.00000 | | |
| 6 | 5.78 | 0.43 | 1.48088 | 2.8 | $L_{1P4}$ ($L_{2P4}$) |
| 7 | -24.55 | 4.43 | 1.00000 | | |
| 8 | 9.60 | 0.33 | 1.48088 | 2.8 | $L_{1N1}$ ($L_{2N1}$) |
| 9 | 6.24 | 1.10 | 1.00000 | | |
| 10 | -10.01 | | -1.00000 | 1.5 | $M_1$ ($M_2$) |

Condition Correspondence Values of Seventh Embodiment

(1) $2(WD - D_2)/\Phi max = 1.39$
(2) $|f_{GN}/f_{GP}| = 6.33$
(3) $q = -4.71$
(4) $L_{NM}/TL = 0.0687$
(5) $L_{GP-GN}/TL = 0.546$
(6) $|r_M/TL| = 1.01$
(7) $f_{GP}/TL = 0.610$

In Table 8, an image height Y is 1.0, and a numerical aperture N.A on the image side is 0.1. The 0th surface corresponds to the object surface or the image surface.

The optical system shown in Table 8 satisfies relation (1) so that a sufficient working distance is ensured.

The total length TL of the first and second imaging optical systems ($K_1$ and $K_2$) of the embodiment shown in Table 8 is 9.92, and the total length TL of the Dyson optical system shown in Table 2 is 58.22. Therefore, the total length of the embodiment shown in Table 8 is as small as about 1/6 that of the Dyson optical system in Fig. 6.

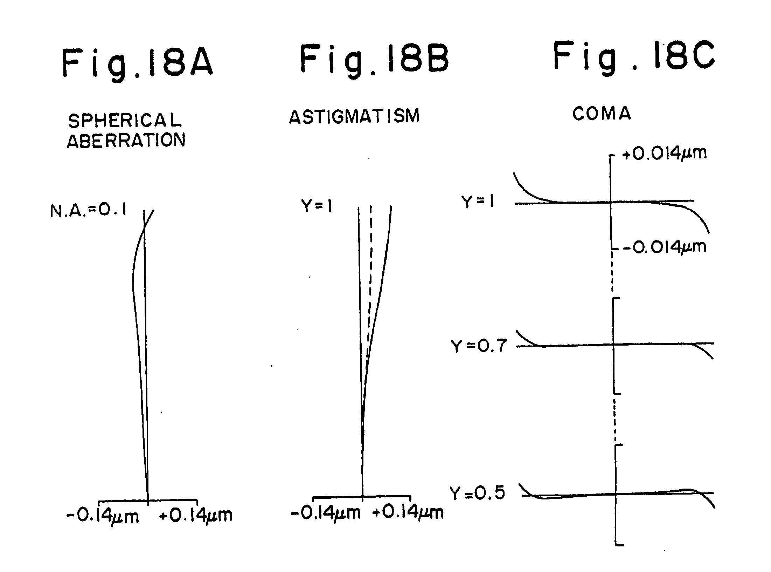

Figs. 18A, 18B and 18C show various aberrations caused by the light beam with an exposure wavelength (g-line: 436 nm) of the embodiment shown in Fig. 17. Comas shown in Fig. 18C are represented by aberration curves at image heights of 1, 0.75, and 0.5. The scale of a coma at each image height is $\pm0.014$ µm. As is apparent from various aberrations shown in Figs. 18A, 18B and 18C, the various aberrations are corrected in a good balance.

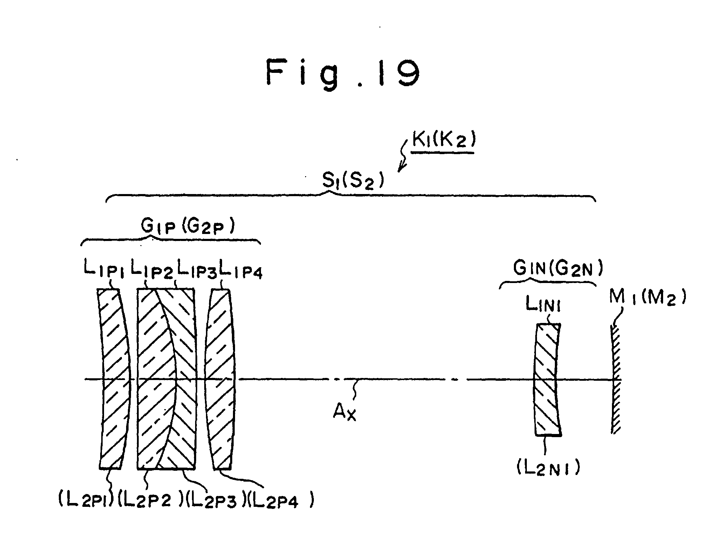

A first imaging optical system $K_1$ (or a second imaging optical system $K_2$) constituting a projection optical system according to the eighth embodiment will be described below with reference to Fig. 19.

Fig. 19 is a view showing the lens arrangement of the first imaging optical system $K_1$ (the a second imaging optical system $K_2$) shown in Fig. 1 according to the eighth embodiment. For the descriptive convenience, the lens arrangement shown in Fig. 19 will be described as that of the first imaging optical system $K_1$.

As shown in Fig. 19, the first imaging optical system $K_1$ (or the second imaging optical system $K_2$) has a first refraction optical system $S_1$ (or a second refraction optical system $S_2$) consisting of a first positive lens group $G_{1P}$ (or a second positive lens group $G_{2P}$) and a first negative lens group $G_{1N}$ (or a second negative lens group $G_{2N}$), and a first concave reflecting mirror $M_1$ (or a second concave reflecting mirror $M_2$). For the descriptive convenience, in Fig. 19, a first rectangular prism $P_1$ (or a second rectangular prism $P_2$) arranged on the left side of the first refraction optical system $S_1$ (or the second refraction optical system $S_2$) is not illustrated.

As shown in Fig. 19, the first positive lens group $G_{1P}$ comprises a positive meniscus lens $L_{1P1}$ having its convex surface facing the first concave reflecting mirror $M_1$ side, a positive meniscus lens $L_{1P2}$ having its convex surface facing the first concave reflecting mirror $M_1$ side, a negative meniscus lens $L_{1P3}$ bonded to the positive meniscus lens $L_{1P2}$ and having its convex surface facing the first concave reflecting mirror $M_1$ side, and a biconvex positive lens $L_{1P4}$ having its surface with a larger curvature facing the negative meniscus lens $L_{1P3}$ side, in this order from the object side to the first concave reflecting mirror $M_1$ side. The first negative lens group $G_{1N}$ comprises a negative meniscus lens $L_{1N1}$ having its convex surface facing the first positive lens group $G_{1P}$ side.

In this embodiment, since the positive meniscus lens $L_{1P2}$ and the negative meniscus lens $L_{1P3}$ in the first positive lens group $G_{1P}$ are constituted as a bonded lens component, a larger decentering tolerance can be set to the two lenses, and the number of components of the first positive lens group $G_{1P}$ itself is decreased. With this arrangement, the projection optical system can be easily manufactured.

Table 9 shows the numerical data of the optical system shown in Fig. 19. Leftmost numbers represent the order from an object O side (or the primary image side) to the first concave reflecting mirror $M_1$ (or the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 9, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); $\Phi max$, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_l$ side of the negative meniscus lens; and $L_{GP-GN}$, the distance from the image-side-principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 9

| Eighth Embodiment | | | | | |
|---|---|---|---|---|---|
| WD = 2.43 | | | | | |
| $D_1$ = 2.16 | | | | | |
| $D_2$ = 0.27 | | | | | |
| $D_{OI}$ = 4.32 | | | | | |
| TL = 9.83 | | | | | |
| | r | d | n | Φ | Optical Member |
| 0 | | 2.43 | 1.00000 | | |
| 1 | -8.43 | 0.39 | 1.48088 | 2.8 | $L_{1P1}$ ($L_{2P1}$) |
| 2 | -4.68 | 0.04 | 1.00000 | | |
| 3 | -27.09 | 0.54 | 1.48088 | 2.8 | $L_{1P2}$ ($L_{2P2}$) |
| 4 | -2.63 | 0.35 | 1.60384 | 2.8 | $L_{1P3}$ ($L_{2P3}$) |
| 5 | -7.41 | 0.04 | 1.00000 | | |
| 6 | 5.15 | 0.43 | 1.48088 | 2.8 | $L_{1P4}$ ($L_{2P4}$) |
| 7 | -33.16 | 4.63 | 1.00000 | | |
| 8 | 9.38 | 0.33 | 1.48088 | 2.8 | $L_{1N1}$ ($L_{2N1}$) |
| 9 | 5.77 | 0.65 | 1.00000 | | |
| 10 | -9.88 | | -1.00000 | 1.5 | $M_1$ ($M_2$) |

Condition Correspondence Values of Eighth Embodiment

(1) 2(WD - $D_2$)/Φmax = 1.54
(2) | $f_{GN}/f_{GP}$ | = 5.53
(3) q = -4.20
(4) $L_{NM}/TL$ = 0.0294
(5) $L_{GP-GN}/TL$ = 0.567
(6) | $r_M/TL$ | = 1.01
(7) $f_{GP}/TL$ = 0.591

In Table 9, an image height Y is 1.0, and a numerical aperture N.A on the image side is 0.1. The 0th surface corresponds to the object surface or the image surface.

The optical system shown in Table 9 satisfies relation (1) so that a sufficient working distance is ensured.

The total length TL of the first and second imaging optical systems ($K_1$ and $K_2$) of the embodiment shown in Table 9 is 9.83, and the total length TL of the Dyson optical system shown in Table 2 is 58.22. Therefore, the total length of the embodiment shown in Table 9 is as small as about 1/6 that of the Dyson optical system in Fig. 6.

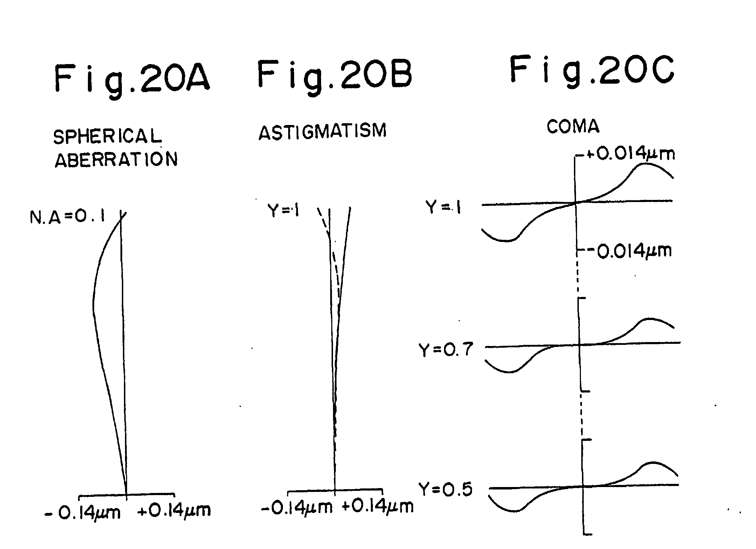

Figs. 20A, 20B and 20C show various aberrations caused by the light beam with an exposure wavelength (g-line: 436 nm) of the embodiment shown in Fig. 19. Comas shown in Fig. 20C are represented by aberration curves at image heights of 1, 0.75, and 0.5. The scale of a coma at each image height is ±0.014 μm. As is apparent from various aberrations shown in Figs. 20A, 20B and 20C, the various aberrations are corrected in a good balance.

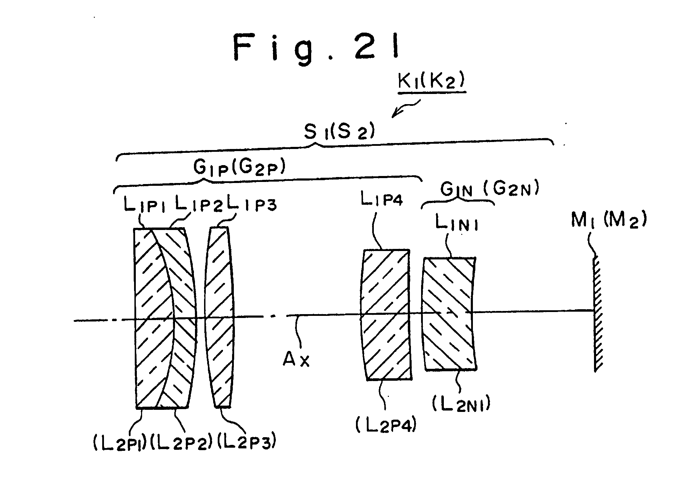

A first imaging optical system $K_1$ (or a second imaging optical system $K_2$) constituting a projection optical system according to the ninth embodiment will be described below with reference to Fig. 21.

Fig. 21 is a view showing the lens arrangement of the first imaging optical system $K_1$ (the a second imaging optical system $K_2$) shown in Fig. 1 according to the ninth embodiment. For the descriptive convenience, the lens arrangement shown in Fig. 21 will be described as that of the first imaging optical system $K_1$.

As shown in Fig. 21, the first imaging optical system $K_1$ (or the second imaging optical system $K_2$) has a first refraction optical system $S_1$ (or a second refraction optical system $S_2$) consisting of a first positive lens group $G_{1P}$ (or a second positive lens group $G_{2P}$) and a first negative lens group $G_{1N}$ (or a second negative lens group $G_{2N}$), and a first concave reflecting mirror $M_1$ (or a second concave reflecting mirror $M_2$). For the descriptive convenience, in Fig. 21, a first rectangular prism $P_1$ (or a second rectangular prism $P_2$) arranged on the left side of the first refraction optical system $S_1$ (or the second refraction optical system $S_2$) is not illustrated.

As shown in Fig. 21, the first positive lens group $G_{1P}$ comprises a positive meniscus lens $L_{1P1}$ having its convex surface facing the first concave reflecting mirror $M_1$ side, a positive meniscus lens $L_{1P2}$ bonded to the positive meniscus lens $L_{1P1}$ and having its convex surface facing the first concave reflecting mirror $M_1$ side, a biconvex positive lens $L_{1P3}$, and a positive meniscus lens $L_{1P4}$ having its convex surface facing the first concave reflecting mirror $M_1$ side, in this order from the object side to the first concave reflecting mirror $M_1$ side. The first negative lens group $G_{1N}$ comprises a negative meniscus lens $L_{1N1}$ having its convex surface facing the first positive lens group $G_{1P}$ side.

In this embodiment, since the positive meniscus lens $L_{1P1}$ and the negative meniscus lens $L_{1P2}$ in the first positive lens group $G_{1P}$ are constituted as a bonded lens component, a larger decentering tolerance can be set to the two lenses, and the number of components of the first positive lens group $G_{1P}$ itself is decreased. With this arrangement, the projection optical system can be easily manufactured.

Table 10 shows the numerical data of the optical system shown in Fig. 21. Leftmost numbers represent the order from an object O side (or the primary image side) to the first concave reflecting mirror $M_1$ (or the second concave reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 10, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); $\Phi$max, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_1$ side of the negative meniscus lens; and $L_{GP-GN}$, the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 10

| Ninth Embodiment | | | | | |
|---|---|---|---|---|---|
| WD = 2.23 | | | | | |
| $D_1$ = 1.96 | | | | | |
| $D_2$ = 0.27 | | | | | |
| $D_{OI}$ = 3.92 | | | | | |
| TL = 9.16 | | | | | |
| | r | d | n | $\Phi$ | Optical Member |
| 0 | | 2.23 | 1.00000 | | |
| 1 | -359.70 | 0.54 | 1.48088 | 2.7 | $L_{1P1}$ ($L_{2P1}$) |
| 2 | -2.41 | 0.33 | 1.60384 | 2.7 | $L_{1P2}$ ($L_{2P2}$) |
| 3 | -4.79 | 0.04 | 1.00000 | | |
| 4 | 7.53 | 0.61 | 1.48088 | 2.7 | $L_{1P3}$ ($L_{2P3}$) |
| 5 | -18.03 | 1.38 | 1.00000 | | |
| 6 | 5.71 | 0.85 | 1.48088 | 2.3 | $L_{1P4}$ ($L_{2P4}$) |

Table 10   (continued)

| Ninth Embodiment | | | | | |
|---|---|---|---|---|---|
| | r | d | n | Φ | Optical Member |
| 7 | 18.35 | 0.11 | 1.00000 | | |
| 8 | 7.39 | 0.84 | 1.60384 | 2.1 | $L_{1N1}$ ($L_{2N1}$) |
| 9 | 3.90 | 2.23 | 1.00000 | | |
| 10 | -9.01 | | -1.00000 | 1.3 | $M_1$ ($M_2$) |

Condition Correspondence Values of Ninth Embodiment

(1) $2(WD - D_2)/\Phi max = 1.45$
(2) $| f_{GN}/f_{GP}| = 3.17$
(3) $q = -3.23$
(4) $L_{NM}/TL = 0.0173$
(5) $L_{GP-GN}/TL = 0.385$
(6) $| r_M/TL| = 0.983$
(7) $f_{GP}/TL = 0.519$

In Table 10, an image height Y is 1.0, and a numerical aperture N.A on the image side is 0.1. The 0th surface corresponds to the object surface or the image surface.

The optical system shown in Table 10 satisfies relation (1) so that a sufficient working distance is ensured.

The total length TL of the first and second imaging optical systems ($K_1$ and $K_2$) of the embodiment shown in Table 10 is 9.16, and the total length TL of the Dyson optical system shown in Table 2 is 58.22. Therefore, the total length of the embodiment shown in Table 10 is as small as about 1/6 that of the Dyson optical system in Fig. 6.

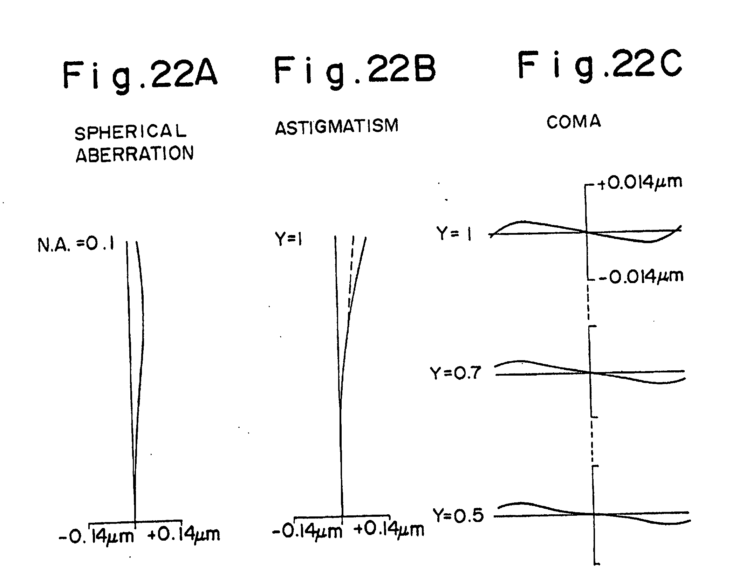

Figs. 22A, 22B and 22C show various aberrations caused by the light beam with an exposure wavelength (g-line: 436 nm) of the embodiment shown in Fig. 21. Comas shown in Fig. 22C are represented by aberration curves at image heights of 1, 0.75, and 0.5. The scale of a coma at each image height is $\pm 0.014$ μm. As is apparent from various aberrations shown in Figs. 22A, 22B and 22C, the various aberrations are corrected in a good balance.

In the first or second imaging optical system ($K_1$ or $K_2$) of each of the above first to ninth embodiments, the rectangular prism $P_1$ or $P_2$ serving as a reflecting mirror having reflecting surfaces crossing each other at 90° is used as the first or second reflecting member. Instead, a prism member having total reflecting surfaces crossing each other at 90° may also be used.

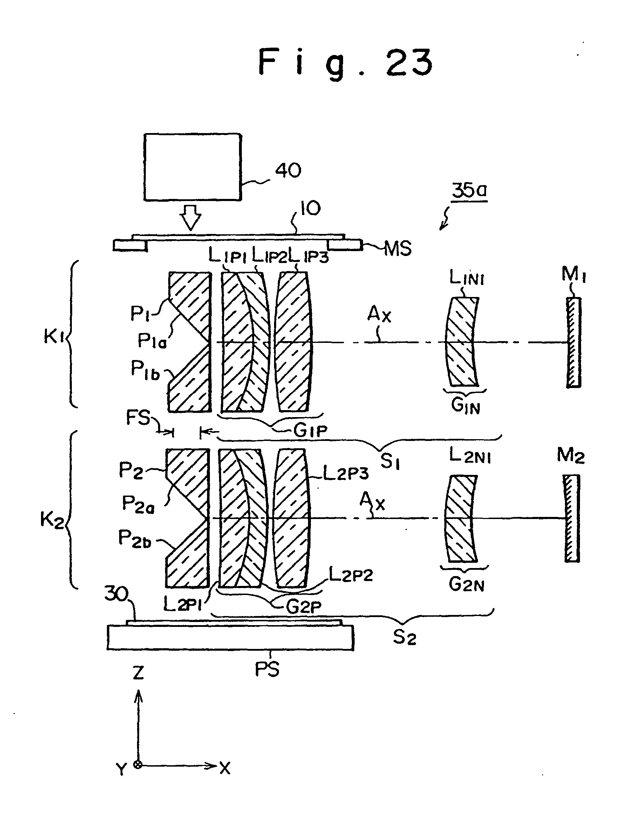

The tenth embodiment in which prism members are used as first or second reflecting members will be described below with reference to Fig. 23.

Fig. 23 is a view schematically showing a projection optical system of an exposure apparatus according to the tenth embodiment of the present invention. In Fig. 23, the X-Y-Z coordinate system as in Fig. 1 is employed, and the same reference numerals denote the same members.

Referring to Fig. 23, a first projection optical system 35a has a first imaging optical system $K_1$ for forming the primary image of a circuit pattern on a mask 10, and a second imaging optical system $K_2$ for forming the erect image (secondary image) of the circuit pattern onto a plate 30 on the basis of a light beam from the primary image. The first imaging optical system $K_1$ has a prism member $P_1$ (first reflecting member) having total reflecting surfaces $P_{1a}$ and $P_{1b}$ inclined by 45° with respect to the plane (X-Y plane) of the mask 10, a first refraction optical system $S_1$ consisting of a first positive lens group $G_{1P}$ and a first negative lens group $G_{1N}$, and a first concave reflecting mirror $M_1$.

The first positive lens group $G_{1P}$ comprises a bonded lens consisting of a positive meniscus lens $L_{1P1}$ having its convex surface facing the first concave reflecting mirror $M_1$ side and a negative meniscus lens $L_{1P2}$ having its convex surface facing the first concave reflecting mirror $M_1$ side, and a biconvex positive lens $L_{1P3}$. The first negative lens group $G_{1N}$ comprises only a negative meniscus lens $L_{1N1}$ having its convex surface facing the first positive lens group $G_{1P}$ side.

The arrangement of the second imaging optical system $K_2$ is the same as that of the first imaging optical system $K_1$. More specifically, the second imaging optical system $K_2$ has a prism member $P_2$ (second reflecting member) having total reflecting surfaces $P_{2a}$ and $P_{2b}$ inclined by 45° with respect to the plane (X-Y plane) of the plate 30, a second refraction optical system $S_2$ consisting of a second positive lens group $G_{2P}$ and a second negative lens group $G_{2N}$, and a second concave reflecting mirror $M_2$.

As in the first positive lens group $G_{1P}$, the second positive lens group $G_{2P}$ comprises a bonded lens consisting of a positive meniscus lens $L_{2P1}$ having its convex surface facing the second concave reflecting mirror $M_2$ side and a negative meniscus lens $L_{2P2}$ having its convex surface facing the second concave reflecting mirror $M_2$ side, and a biconvex positive lens $L_{2P3}$. The second negative lens group $G_{2N}$ comprises only a negative meniscus lens $L_{2N1}$ having its convex surface facing the second positive lens group $G_{2P}$ side.

A field stop FS for regulating the projection area on the plate 30 is provided at the position where the primary image of the circuit pattern is formed by the first imaging optical system $K_1$. The arrangement of this field stop FS is the same as in the embodiment shown in Figs. 1, 2A, 2B and 2C, and a detailed description thereof will be omitted.

The circuit pattern on the mask 10 is illuminated with an illumination light beam (exposure light beam) from an illumination optical system 40 at an almost uniform illuminance. The light beam from the circuit pattern propagates along the -Z direction in Fig. 23 is incident on the prism member $P_1$, deflected by 90° by the total reflecting surface $P_{1a}$ of the prism member $P_1$, propagates along the +X direction in Fig. 23, and exits from the prism member $P_1$. The light beam from the prism member $P_1$ is incident on the first positive lens group $G_{1P}$ ($L_{1P1}$ to $L_{1P4}$) and reaches the first concave reflecting mirror $M_1$ through the first negative lens group $G_{1N}$ ($L_{1N1}$). The first concave reflecting mirror $M_1$ is arranged almost at the rear focal position of the first refraction optical system $S_1$ ($G_{1P}$ and $G_{1N}$). That is, the first concave reflecting mirror $M_1$ is located at the pupil plane of the first imaging optical system $K_1$. The rear focal position of the first refraction optical system $S_1$ is obtained when the prism member $P_1$ side is defined as a front side, and the first concave reflecting mirror $M_1$ side is defined as a rear side.

The light beam reflected by the first concave reflecting mirror $M_1$ propagates along the -X direction in Fig. 1 through the first negative lens group $G_{1N}$ ($L_{1N1}$) and the first positive lens group $G_{1P}$ ($L_{1P1}$ to $L_{1P4}$) and is incident on the rectangular prism $P_1$. The light beam incident on the rectangular prism $P_1$ is deflected by about 90° by the total reflecting surface $P_{1b}$ provided in the rectangular prism $P_1$, propagates along the -Z direction in Fig. 23, and forms the primary image of the circuit pattern at the position of the field stop FS. In this primary image, the transverse magnification in the X direction is almost +1 time, and the transverse magnification in the Y direction is almost -1 time.

The light beam from the primary image forms the secondary image of the circuit pattern onto the plate 30 through the second imaging optical system $K_2$. The transverse magnifications in the X and Y directions of this secondary image are almost +1 time. That is, the secondary image formed on the plate 30 is an erect image. The function of the second imaging optical system $K_2$ is the same as that of the first imaging optical system $K_1$, and a detailed description thereof will be omitted.

In this embodiment as well, since the image of the circuit pattern, which is formed on the plate 30, is an erect image, scanning exposure can be performed by performing an exposure operation while integrally moving the mask 10 held by a mask stage MS and the plate 30 held by a plate stage PS in the same direction.

Telecentricity is achieved in the first imaging optical system $K_1$ on the mask 10 side and on the field stop FS side because the first concave reflecting mirror is arranged at the rear focal position of the first refraction optical system $S_1$. Similarly, telecentricity is achieved in the second imaging optical system $K_2$ on the field stop FS side and on the plate 30 side because the second concave reflecting mirror $M_2$ is arranged at the rear focal position of the first refraction optical system $S_2$. That is, the first projection optical system 35a is a both-side telecentric optical system (on the mask 10 side and on the plate 30 side).

In this embodiment, a plurality of projection optical systems each having the same arrangement as that of the first projection optical system 35a are arranged, as shown in Fig. 3. The arrangement of these projection optical systems is the same as in Fig. 3, and a detailed description thereof will be omitted.

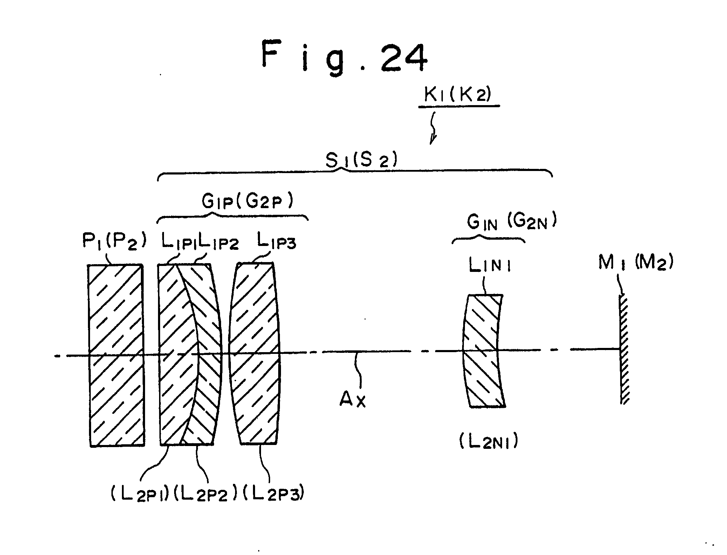

Fig. 24 is a view showing the lens arrangement of the first imaging optical system $K_1$ (or the second imaging optical system $K_2$) shown in Fig. 23, in which the prism member $P_1$ (or the prism member $P_2$) is illustrated as a plane-parallel plate.

As shown in Fig. 24, in this embodiment, the bonded lenses $L_{1P1}$ and $L_{1P2}$ (or $L_{2P1}$ and $L_{2P2}$) are arranged in the first positive lens group $G_{1P}$ (or the second positive lens group $G_{2P}$). With this arrangement, the number of components of the first positive lens group $G_{1P}$ (or the second positive lens group $G_{2P}$) itself can be decreased, and a larger decentering tolerance can be set to the first positive lens group $G_{1P}$ (or the second positive lens group $G_{2P}$). Therefore, the projection optical system can be easily manufactured.

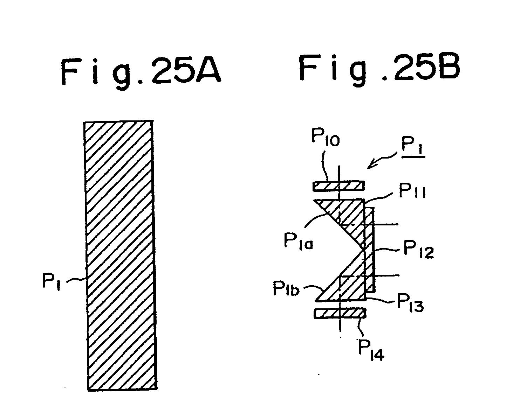

In the embodiment shown in Fig. 24, the plane-parallel plate corresponding to the prism member $P_1$ (or the prism member $P_2$) can also be divided. More specifically, the prism plate $P_1$ consisting of a plane-parallel plate as shown in Fig. 25A can be divided into rectangular prisms $P_{11}$ and $P_{13}$ having the total reflecting surfaces $P_{1a}$ and $P_{1b}$ and plane-parallel plates $P_{10}$, $P_{12}$, and $P_{14}$, as shown in Fig. 25B. In the example shown in Fig. 25B, the plane-parallel plate $P_{12}$ bonded to the rectangular prisms $P_{11}$ and $P_{13}$ has a function of supporting the two rectangular prisms $P_{11}$ and $P_{13}$. The plane-parallel plates $P_{10}$ and $P_{14}$ are arranged to be rotated about an axis corresponding to a direction perpendicular to the optical axis, thereby obtaining a function of moving the field or image in a plane perpendicular to the optical axis, i.e., the function of so-called halving glass.

Table 11 shows the numerical data of the optical system shown in Fig. 24. Leftmost numbers represent the order from an object O side (or the primary image side) to the first concave reflecting mirror $M_1$ (or the second concave

reflecting mirror $M_2$); r, the radius of curvature of a lens surface or a reflecting surface; d, the distance between lens surfaces; n, the refractive index of a medium (optical material) with respect to a light beam with an exposure wavelength (g-line: 436 nm); and $\Phi$, the outer diameter of a medium (optical material). In Table 11, WD represents the working distance of the first imaging optical system $K_1$; $D_1$, the distance from the object surface O to the vertex of the rectangular prism $P_1$ (a point on the ridgeline formed by the two reflecting surfaces perpendicular to each other) in the first imaging optical system $K_1$ (the distance from the object surface O to an optical axis AX of the first imaging optical system $K_1$); $D_2$, the distance from the vertex of the rectangular prism $P_1$ to the vertex of the positive meniscus lens $L_{1P1}$ on the prism $P_1$ side; $D_{OI}$, the distance from the object surface O (mask) to an image surface I (primary image surface); $\Phi$max, the maximum outer diameter of the first or second imaging optical system ($K_1$ or $K_2$); $f_{GP}$, the focal length of the first positive lens group $G_{1P}$ (or the second positive lens group $G_{2P}$); $f_{GN}$, the focal length of the first negative lens group $G_{1N}$ (or the second negative lens group $G_{2N}$); TL, the distance (total length) on the optical axis AX from the object surface O to the first concave reflecting mirror $M_1$ (or the second concave reflecting mirror $M_2$); $r_M$, the radius of curvature of the first concave reflecting mirror $M_1$ (or the second concave reflecting mirror $M_2$); $r_{1N}$, the radius of curvature of the lens surface of the negative meniscus lens of the first negative lens group $G_{1N}$ on the first positive lens group $G_{1P}$ side; $r_{2N}$, the radius of curvature of the lens surface of the negative meniscus lens on the first concave reflecting mirror $M_1$ side; $L_{NM}$, the distance on the optical axis from the image-side principal point to the first concave reflecting mirror $M_1$, which image side corresponds to the first concave reflecting mirror $M_1$ side of the negative meniscus lens; and $L_{GP-GN}$, the distance from the image-side principal point, which image side corresponds to the first concave reflecting mirror $M_1$ side of the first positive lens group $G_{1P}$, to the image-side principal point, which image side corresponds to the first concave reflecting mirror $M_1$ side of the first negative lens group $G_{1N}$.

Table 11

| Tenth Embodiment | | | | | |
|---|---|---|---|---|---|
| WD = 2.49 | | | | | |
| $D_1$ = 2.38 | | | | | |
| $D_2$ = 0.11 | | | | | |
| $D_{OI}$ = 4.72 | | | | | |
| TL = 9.70 | | | | | |
| | r | d | n | $\Phi$ | Optical Member |
| 0 | | 1.40 | 1.00000 | | |
| 1 | 0.00 | 0.98 | 1.59422 | | $P_1$ ($P_2$) |
| 2 | 0.00 | 0.11 | 1.00000 | | |
| 3 | -17.17 | 0.56 | 1.48088 | 2.7 | $L_{1P1}$ ($L_{2P1}$) |
| 4 | -2.30 | 0.27 | 1.60384 | 2.7 | $L_{1P2}$ ($L_{2P2}$) |
| 5 | -4.25 | 0.04 | 1.00000 | | |
| 6 | 7.35 | 0.70 | 1.48088 | 2.7 | $L_{1P3}$ ($L_{2P3}$) |
| 7 | 18.96 | 3.25 | 1.00000 | | |
| 8 | 3.47 | 0.62 | 1.60384 | 2.0 | $L_{1N1}$ ($L_{2N1}$) |
| 9 | 3.20 | 2.13 | 1.00000 | | |
| 10 | -10.05 | | -1.00000 | 1.8 | $M_1$ ($M_2$) |

Condition Correspondence Values of Tenth Embodiment

(1) $2(WD - D_2)/\Phi$max = 1.76
(2) $|f_{GN}/f_{GP}|$ = 84.6
(3) q = -24.8
(4) $L_{NM}/TL$ = -3.57
(5) $L_{GP-GN}/TL$ = 4.22
(6) $|r_M/TL|$ = 1.04
(7) $f_{GP}/TL$ = 0.665

In Table 11, an image height Y is 1.0, and a numerical aperture N.A on the image side is 0.1. The 0th surface corresponds to the object surface or the image surface. In Table 11, the distance TL on the optical axis AX from the object surface O to the first concave reflecting mirror $M_1$ (or the second concave reflecting mirror $M_2$) represents the air conversion length of the prism member $P_1$ (or the prism member $P_2$).

The optical system shown in Table 11 satisfies relation (1) so that a sufficient working distance is ensured.

The total length TL of the first and second imaging optical systems ($K_1$ and $K_2$) of the embodiment shown in Table 11 is 9.70, and the total length TL of the Dyson optical system shown in Table 2 is 58.22. Therefore, the total length of the embodiment shown in Table 11 is as small as about 1/6 that of the Dyson optical system in Fig. 6.

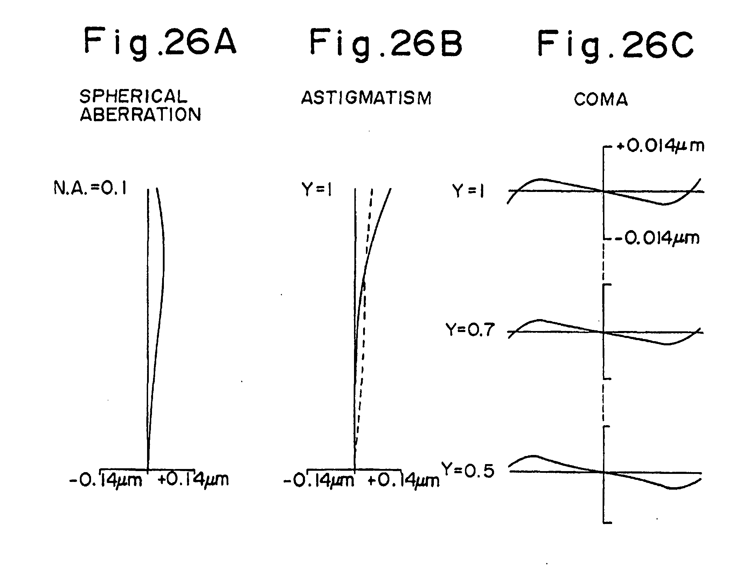

Figs. 26A, 26B and 26C show various aberrations caused by the light beam with an exposure wavelength (g-line: 436 nm) of the embodiment shown in Fig. 24. Comas shown in Fig. 22C are represented by aberration curves at image heights of 1, 0.75, and 0.5. The scale of a coma at each image height is $\pm 0.014$ μm. As is apparent from various aberrations shown in Figs. 26A, 26B and 26C, the various aberrations are corrected in a good balance.

Ten examples of an optimum optical system constituting the first or second imaging optical system ($K_1$ or $K_2$) have been described above with reference to Figs. 4, 7, 9, 11, 13, 15, 17, 19, 21, and 24. However, both the first and second imaging optical systems ($K_1$ and $K_2$) need not be constituted by identical optical systems. For example, the first imaging optical system $K_1$ can be constituted by one of the ten optical systems shown in Figs. 4, 7, 9, 11, 13, 15, 17, 19, 21, and 24 while the second imaging optical system $K_2$ can be constituted by any other of the ten optical systems, as a matter of course.

According to each of the above embodiments, a wide exposure area can be formed in a direction perpendicular to the scanning direction by a plurality of projection optical systems. For this reason, the exposure area can be extended without increasing the size of the individual projection optical systems. In addition, in each of the above embodiments, since size reduction of the projection optical system can be achieved, an increase in aberration according to an increase in size of the optical system can be suppressed. Furthermore, in each of the above embodiments, an exposure operation of a large screen can be performed by one-shot scanning exposure. Therefore, an increase in throughput can be achieved, and a seamless screen can be formed.

As has been described above, according to the present invention, a high-performance and compact exposure apparatus which can perform a projection exposure operation with satisfactory optical performance by using a plurality of compact projection optical systems each capable of ensuring a sufficient working distance and having excellent imaging performance, while preventing a decrease in throughput even in a large exposure area, can be achieved.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

The basic Japanese Applications No.5835/1995 filed on January 18, 1995 and No.136779/1995 filed on June 2, 1995 are hereby incorporated by reference.

**Claims**

1. An exposure apparatus for projecting and transferring an image of a first object (10) onto a second object (30) while moving said first and second object in a predetermined moving direction, comprising

a first plurality of both-side telecentric projection optical systems (35a, 35b, 35c, 35d) and a second plurality both-side telecentric projection optical systems (35e, 35f, 35g) provided for forming a real-size erect image with positive horizontal and vertical magnifications of said first object (10) on said second object (30) and arranged so as to provide a wide exposure region in a direction perpendicular to a direction of movement of said first and second object,

wherein the first and the second plurality of said projection optical systems are spaced in a first direction parallel to said moving direction, and

wherein, within each plurality, the projection optical systems are spaced in a second direction perpendicular to said moving direction, and

wherein image areas produced by said projection optical systems of said first and second plurality overlap each other by moving said first and second objects in said moving direction; and

wherein said projection optical systems each comprise

a first both-side telecentric projection optical system (35a) for forming a real-size erect image with positive horizontal and vertical magnifications of said first object (10) on said second object (30); and

a second both-side telecentric projection optical system (35b) for forming a real-size erect image with positive horizontal and vertical magnifications of said first object (10) on said second object (30);

each of said first and second projection optical systems (35a, 35b) comprising

a first imaging optical system (K1) for condensing a light beam from said first object (10) to form a primary image; and

a second imaging optical system (K2) for condensing a light beam from said primary image to form a secondary image;

said first imaging optical system (K1) comprising

a first positive lens group ((G1P) having a positive refractive power;

a first negative lens group (G1N) having a negative refractive power;

a first concave reflecting mirror (M1),

wherein the light beam from said first object (10) passes through said first positive lens group (G1P) and said first negative lens group (G1N) to said first concave mirror (M1), and after reflection thereby passes through said first negative lens group (G1N) and said first positive lens group (G1P) again, thereby forming said primary image;

said second imaging optical system (K2) comprising

a second positive lens group ((G2P) having a positive refractive power;

a second negative lens group (G2N) having a negative refractive power;

a second concave reflecting mirror (M2),

wherein the light beam from said primary image passes through said second positive lens group (G2P) and said second negative lens group (G2N), is reflected to said second concave mirror (M2), and after reflection thereby passes through said second negative lens group (G2N) and said second positive lens group (G2P) again, thereby forming said secondary image.

2. An exposure apparatus according to Claim 1, wherein when a focal length of said first positive lens group in said first imaging optical system is $f_{GP}$, and a focal length of said first negative lens group in said first imaging optical system is $f_{GN}$, the following relation is satisfied:

$$3 < | f_{GN}/f_{GP}| .$$

3. An exposure apparatus according to Claim 1 or 2, wherein when a focal length of said second positive lens group in said second imaging optical system is $f_{GP}$, and a focal length of said second negative lens group in said second imaging optical system is $f_{GN}$, the following relation is satisfied:

$$3 < | f_{GN}/f_{GP}|.$$

4. An exposure apparatus according to any one of Claims 1 to 3 wherein said first negative lens group includes a negative meniscus lens having a convex surface facing a first positive lens group side,

and wherein when a radius of curvature of a lens surface of said negative meniscus lens on said first positive lens group side is $r_{1N}$, a radius of curvature of a lens surface of said negative meniscus lens on a first concave reflecting mirror side is $r_{2N}$, a distance on an optical axis from an image-side principal point to said first concave reflecting mirror, which image side corresponds to said first concave reflecting mirror side of said negative meniscus lens, is $L_{NM}$, and a distance on an optical axis from said first object to said first concave reflecting mirror is TL, the following relations are satisfied:

$$-30 < q < -3$$

$$-4 < L_{NM}/TL < 0.2$$

where $q = (r_{2N} + r_{1N})/(r_{2N} - r_{1N})$.

5. An exposure apparatus according to any one of Claims 1 to 4 wherein said second negative lens group includes a negative meniscus lens having a convex surface facing a second positive lens group side,

and wherein when a radius of curvature of a lens surface of said negative meniscus lens on said second positive lens group side is $r_{1N}$, a radius of curvature of a lens surface of said negative meniscus lens on a second concave reflecting mirror side is $r_{2N}$, a distance on an optical axis from an image-side principal point to said second concave reflecting mirror, which image side corresponds to said second concave reflecting mirror side of said negative meniscus lens, is $L_{NM}$, and a distance on an optical axis from said first object to said first concave reflecting mirror is TL, the following relations are satisfied:

$$-30 < q < -3$$

$$-4 < L_{NM}/TL < 0.2$$

where $q = (r_{2N} + r_{1N})/(r_{2N} - r_{1N})$.

6. An exposure apparatus according to any one of Claims 1 to 5 wherein when a distance from an image-side principal point, which image side corresponds to a first concave reflecting mirror side of said first positive lens group, to an image-side principal point, which image side corresponds to a first concave reflecting mirror side of said first negative lens group is $L_{GP-GN}$, and a distance on an optical axis from said first object to said first concave reflecting mirror is TL, the following relation is satisfied:

$$0.35 < L_{GP-GN}/TL.$$

7. An exposure apparatus according to any one of Claims 1 to 6 wherein when a distance from an image-side principal point, which image side corresponds to a second concave reflecting mirror side of said second positive lens group, to an image-side principal point, which image side corresponds to a second concave reflecting mirror side of said second negative lens group is $L_{GP-GN}$, and a distance on an optical axis from said first object to said second concave reflecting mirror is TL, the following relation is satisfied:

$$0.35 < L_{GP-GN}/TL.$$

8. An exposure apparatus according to any one of Claims 1 to 7 wherein when a radius of curvature of said first concave reflecting mirror in said first imaging optical system is $r_M$, a focal length of said first positive lens group is $f_{GP}$, and a distance on an optical axis from said first object to said first concave reflecting mirror is TL, the following relations are satisfied:

$$0.95 < | r_M/TL| < 1.08$$

$$0.3 < f_{GP}/TL < 1.0.$$

9. An exposure apparatus according to any one of Claims 1 to 8 wherein when a radius of curvature of said second concave reflecting mirror in said second imaging optical system is $r_M$, a focal length of said second positive lens group is $f_{GP}$, and a distance on an optical axis from said primary image to said second concave reflecting mirror is TL, the following relations are satisfied:

$$0.95 < | r_M/TL| < 1.08$$

$$0.3 < f_{GP}/TL < 1.0.$$

10. An exposure apparatus according to Claim 1, wherein said first negative lens group has a positive lens and a negative meniscus lens having a concave surface facing said first positive lens group side, in an order from a first positive lens group side,

and wherein said second negative lens group has a positive lens and a negative meniscus lens having a concave surface facing said second positive lens group side, in an order from a second positive lens group side.

11. An exposure apparatus according to Claim 1, wherein said first negative lens group has a negative meniscus lens bonded to said first concave reflecting mirror,

and wherein said second negative lens group has a negative meniscus lens bonded to said second concave reflecting mirror.

**12.** An exposure apparatus according to Claim 1, wherein said first imaging optical system has a first reflecting member for deflecting a light beam from said first object toward said first positive lens group and deflecting the light beam from said first positive lens group toward said second imaging optical system,

and wherein said second imaging optical system has a second reflecting member for deflecting the light beam from said first imaging optical system toward said second positive lens group and deflecting the light beam from said second positive lens group toward said second object.

**13.** A method of manufacturing a display panel comprising the . steps of:

preparing a mask;

preparing a photosensitive substrate; and

projective transferring a real erect image of a pattern on said mask, on said photosensitive substrate by using an exposure apparatus according to any one of Claims 1 to 12.

**Patentansprüche**

**1.** Eine Belichtungsvorrichtung zum Projizieren und Übertragen eines Bildes eines ersten Objekts (10) auf ein zweites Objekt (30), wobei das erste und zweite Objekt in einer vorgegebenen Bewegungsrichtung bewegt werden, umfassend:

eine erste Vielzahl von beidseitig telezentrischen optischen Projektionssystemen (35a, 35b, 35c, 35d) und eine zweite Vielzahl von beidseitig telezentrischen optischen Projektionssystemen (35e, 35f, 35g), bereitgestellt zum Bilden eines aufgerichteten Realgrößenbildes mit positiver horizontaler und vertikaler Vergrößerung des ersten Objekts (10) auf das zweite Objekt (30), und so angeordnet, dass ein weiter Belichtungsbereich in einer zur Bewegungsrichtung des ersten und zweiten Objekts rechtwinkligen Richtung bereitgestellt wird,

wobei die erste und die zweite Vielzahl von optischen Projektionssystemen in einer ersten Richtung parallel zur Bewegungsrichtung beabstandet sind, und

wobei, innerhalb jeder Vielzahl, die optischen Projektionssysteme in einer zweiten Richtung beabstandet sind, die rechtwinklig zur Bewegungsrichtung ist, und

wobei die durch die optischen Projektionssysteme der ersten und zweiten Vielzahl erzeugten Bildbereiche einander durch ein Bewegen des ersten und zweiten Objekts in der Bewegungsrichtung überlappen;

wobei die optischen Projektionssysteme jeweils umfassen:

ein beidseitig telezentrisches optisches Projektionssystem (35a), zum Bilden eines aufgerichteten Realgrößenbildes mit positiver horizontaler und vertikaler Vergrößerung des ersten Objekts (10) auf das zweite Objekt (30); und

ein zweites beidseitig telezentrisches optisches Projektionssystem (35b) zum Bilden eines aufgerichteten Realgrößenbildes mit positiver horizontaler und vertikaler Vergrößerung des ersten Objekts (10) auf das zweite Objekt (30);

wobei das erste und das zweite optische Projektionssystem (35a, 35b) jeweils umfasst:

ein erstes optisches Bildgebungssystem (K1) zum Sammeln eines Lichtstrahls von dem ersten Objekt (10) zur Bildung eines Primärbildes;

ein zweites optisches Bildgebungssystem (K2) zum Sammeln eines Lichtstrahls von dem Primärbild, um ein Sekundärbild zu erzeugen;

wobei das erste optische Bildgebungssystem (K1) umfasst:

eine erste positive Linsengruppe (G1P) mit einer positiven Brechkraft;

eine erste negative Linsengruppe (G1N) mit einer negativen Brechkraft;

einen ersten konkaven Reflektionsspiegel (M1),

wobei der Lichtstrahl von dem ersten Objekt (10) durch die erste positive Linsengruppe (G1P) und die zweite negative Linsengruppe (G1N) zu dem ersten konkaven Spiegel (M1) hindurchtritt, und nach einer Reflektion von diesem wiederum durch die erste negative Linsengruppe (G1N) und die erste positive Linsengruppe (G1P) hindurchtritt, wodurch das Primärbild gebildet wird;

wobei das zweite optische Bildgebesystem (K2) umfasst:

eine zweite positive Linsengruppe (G2P) mit einer positiven Brechkraft;

eine zweite negative Linsengruppe (G2N) mit einer negativen Brechkraft;

einen zweiten konkaven Reflektionsspiegel (M2),

wobei der Lichtstrahl von dem Primärbild durch die zweite positive Linsengruppe (G2P) und die zweite negative Linsengruppe (G2N) hindurchtritt, zum zweiten konkaven Spiegel (N2) reflektiert wird, und nach einer Reflektion von diesem wiederum durch die zweite negative Linsengruppe (G2N) und die zweite positive Linsengruppe (G2P) hindurchtritt, wobei das Sekundärbild erzeugt wird.

2. Eine Belichtungsvorrichtung nach Anspruch 1, wobei dann, wenn eine Fokuslänge der ersten positiven Linsengruppe in dem ersten optischen Bildgebesystem $f_{GP}$ und eine Fokuslänge der ersten negativen Linsengruppe in dem ersten optischen Bildgebesystem $f_{GN}$ ist, die folgende Beziehung erfüllt ist:

$$3 < |f_{GN}/f_{GP}|.$$

3. Eine Belichtungsvorrichtung nach Anspruch 1 oder 2, wobei dann, wenn eine Fokuslänge der zweiten positiven Linsengruppe in dem zweiten optischen Bildgebesystem $f_{GP}$ ist, und eine Fokuslänge der zweiten negativen Linsengruppe in dem zweiten optischen Bildgebesystem $f_{GN}$ ist, die folgende Beziehung erfüllt ist:

$$3 < |f_{GN}/f_{GP}|.$$

4. Eine Belichtungsvorrichtung nach einem der Ansprüche 1 bis 3, wobei die erste negative Linsengruppe eine negative Meniskuslinse mit einer konvexen Oberfläche enthält, die einer ersten positiven Linsengruppenseite gegenüberliegt,
und wobei dann, wenn ein Krümmungsradius einer Linsenoberfläche der negativen Meniskuslinse auf der Seite der ersten positiven Linsengruppe $r_{1N}$ ist, ein Krümmungsradius einer Linsenoberfläche der negativen Meniskuslinse auf einer Seite des ersten konkaven Reflektionsspiegels $r_{2N}$ ist, ein Abstand entlang einer optischen Achse von einem bildseitigen Prinzipalpunkt zu dem ersten konkaven Reflektionsspiegel, wobei die Bildseite der ersten konkaven Reflektionsspiegelseite der negativen Meniskuslinse entspricht, $L_{NM}$ ist, und ein Abstand entlang einer optischen Achse von dem ersten Objekt zu dem ersten konkaven Reflektionsspiegel TL ist, die folgenden Beziehungen erfüllt sind:

$$-30 < q < -3$$

$$-4 < L_{NM}/TL < 0,2$$

wobei $q = (r_{2N} + r_{1N})/(r_{2N})$.

5. Eine Belichtungsvorrichtung nach einem der Ansprüche 1 bis 4, wobei die zweite negative Linsengruppe eine negative Meniskuslinse mit einer konvexen Oberfläche aufweist, die einer Seite der zweiten positiven Linsengruppe gegenüberliegt, und wobei dann, wenn ein Krümmungsradius einer Linsenoberfläche der negativen Meniskuslinse auf der Seite der zweiten positiven Linsengruppe $r_{1N}$ ist, ein Krümmungsradius einer Linsenoberfläche der negativen Meniskuslinse auf einer Seite des zweiten konkaven Reflektionsspiegels $r_{2N}$ ist, ein Abstand entlang einer optischen Achse von einem bildseitigen Prinzipalpunkt zu dem zweiten konkaven Reflektionsspiegel, wobei die Bildseite der Seite des zweiten konkaven Reflektionsspiegels der negativen Meniskuslinse entspricht, $L_{NM}$ ist, und ein Abstand entlang einer optischen Achse von dem ersten Objekt zu dem ersten konkaven Reflektionsspiegel TL ist, die folgenden Bezüge erfüllt sind:

$$-30 < q < -3$$

$$-4 < L_{NM}/TL < 0,2$$

wobei $q = (r_{2N} + r_{1N}) / r_{2N} - r_{1N}$).

**6.** Eine Belichtungsvorrichtung nach einem der Ansprüche 1 bis 5, wobei dann, wenn ein Abstand von einem bildseitigen Prinzipalpunkt, wobei die Bildseite einer Seite des ersten konkaven Reflektionsspiegels der ersten positiven Linsengruppe entspricht, zu einem bildseitigen Prinzipalpunkt, wobei die Bildseite einer Seite des ersten konkaven Reflektionsspiegels der ersten negativen Linsengruppe entspricht, $L_{GP\text{-}GN}$ ist, und ein Abstand entlang einer optischen Achse von dem ersten Objekt zu dem ersten konkaven Reflektionsspiegel TL ist, die folgende Beziehung erfüllt ist:

$$0,35 < L_{GP\text{-}GN}/TL.$$

**7.** Eine Belichtungsvorrichtung nach einem der Ansprüche 1 bis 6, wobei dann, wenn ein Abstand von einem bildseitigen Prinzipalpunkt, wobei die Bildseite einer Seite eines zweiten konkaven Reflektionsspiegels der zweiten positiven Linsengruppe entspricht, zu einem bildseitigen Prinzipalpunkt, wobei die Bildseite einer Seite des zweiten konkaven Reflektionsspiegels der zweiten negativen Linsengruppe entspricht, $L_{GP\text{-}GN}$ ist, und ein Abstand entlang einer optischen Achse von dem ersten Objekt zu dem zweiten konkaven Reflektionsspiegel TL ist, die folgende Beziehung erfüllt ist:

$$0,35 < L_{GP\text{-}GN}/TL.$$

**8.** Eine Belichtungsvorrichtung nach einem der Ansprüche 1 bis 7, wobei dann, wenn ein Kurvenradius des ersten konkaven Reflektionsspiegels in dem ersten optischen Bildgebesystem $r_M$ ist, eine Fokuslänge der ersten positiven Linsengruppe $f_{GP}$ ist, und ein Abstand entlang einer optischen Achse von dem ersten Objekt zu dem ersten konkaven Reflektionsspiegel TL ist, die folgenden Bezüge erfüllt sind:

$$0,95 < | r_M/TL| < 1,08$$

$$0,3 < f_{GP}/TL < 1,0.$$

**9.** Eine Belichtungsvorrichtung nach einem der Ansprüche 1 bis 8, wobei dann, wenn ein Krümmungsradius des zweiten konkaven Reflektionsspiegels in dem zweiten optischen Bildgebesystem $r_M$ ist, eine Fokuslänge der zweiten positiven Linsengruppe $f_{GP}$ ist, und ein Abstand entlang einer optischen Achse von dem Primärbild zu dem zweiten konkaven Reflektionsspiegel TL ist, die folgenden Bezüge erfüllt sind:

$$0,95 < | r_M/TL| < 1,08$$

$$0,3 < f_{GP}/TL < 1,0.$$

**10.** Eine Belichtungsvorrichtung nach Anspruch 1, wobei die erste negative Linsengruppe eine positive Linse aufweist und eine negative Meniskuslinse, mit einer konkaven Oberfläche, die der Seite der ersten positiven Linsengruppe gegenüberliegt, in einer Folge von der Seite der ersten positiven Linsengruppe, und wobei die zweite negative Linsengruppe eine positive Linse aufweist und eine negative Meniskuslinse, mit einer konkaven Oberfläche, die der Seite der zweiten positiven Linsengruppe gegenüberliegt, in einer Folge von einer Seite der zweiten positiven Linsengruppe.

11. Eine Belichtungsvorrichtung nach Anspruch 1, wobei die erste negative Linsengruppe eine negative Meniskuslinse aufweist, die an den ersten konkaven Reflektionsspiegel angebracht ist, und wobei die zweite negative Linsengruppe eine negative Meniskuslinse aufweist, die an dem zweiten konkaven Reflektionsspiegel befestigt ist.

12. Eine Belichtungsvorrichtung nach Anspruch 1, wobei das erste optische Bildgebesystem ein erstes Reflektionsbauteil aufweist, zum Ablenken eines Lichtstrahls von dem ersten Objekt in Richtung der ersten positiven Linsengruppe, und zum Ablenken des Lichtstrahls von der ersten positiven Linsengruppe in Richtung des zweiten optischen Bildgebesystems, und wobei das zweite optische Bildgebesystem ein zweites Reflektionsbauteil aufweist, zum Ablenken des Lichtstrahls von dem ersten optischen Bildgebesystem in Richtung der zweiten positiven Linsengruppe, und zum Ablenken des Lichtstrahls von der zweiten positiven Linsengruppe in Richtung des zweiten Objekts.

13. Ein Verfahren zum Herstellen einer Anzeigefläche, die Schritte umfassend:

Bereitstellen einer Maske;

Bereitstellen eines photosensitiven Substrats; und

projektives Transferieren eines aufgerichteten Realbildes eines Musters auf der Maske, auf das photosensitive Substrat unter Verwendung einer Belichtungsvorrichtung in Übereinstimmung mit einem der Ansprüche 1 bis 12.

**Revendications**

1. Appareil d'exposition pour projeter et transférer une image d'un premier objet (10) sur un second objet (30) tout en déplaçant ledit premier objet et ledit second objet dans une direction de déplacement prédéterminée, comprenant une première pluralité de systèmes optiques de projection télécentrique sur les deux côtés (35a, 35b, 35c, 35d) et une seconde pluralité de systèmes optiques de projection télécentrique sur les deux côtés (35e, 35f, 35g) prévus pour former une image redressée de dimension réelle avec des grossissements horizontal et vertical positifs dudit premier objet (10) sur ledit second objet (30) et disposés de façon à procurer une région de large exposition dans une direction perpendiculaire à une direction de déplacement dudit premier objet et dudit second objet, dans lequel les première et seconde pluralités desdits systèmes optiques de projection sont espacés dans une première direction parallèle à ladite direction de déplacement, et dans lequel, à l'intérieur de chaque pluralité, les systèmes optiques de projection sont espacés dans une seconde direction perpendiculaire à ladite direction de déplacement, et dans lequel des zones d'image produites par lesdits systèmes optiques de projection desdites première et seconde pluralités, se chevauchent l'une l'autre en déplaçant lesdits premier et second objets dans ladite direction de déplacement ; et dans lequel lesdits systèmes optiques de projection comprennent chacun un premier système optique de projection télécentrique sur les deux côtés (35a) pour former une image redressée de dimension réelle avec des grossissements horizontal et vertical positifs dudit premier objet (10) sur ledit second objet (30) ; et un second système optique de projection télécentrique sur les deux côtés (35b) pour former une image redressée de dimension réelle avec des grossissements horizontal et vertical positifs dudit premier objet (10) sur ledit second objet (30) ; chacun desdits premier et second systèmes optiques de projection (35a, 35b) comprenant un premier système optique de formation d'image (K1) pour condenser un faisceau lumineux provenant dudit premier objet (10) pour former une image primaire ; et un système optique de formation d'image (K2) pour condenser un faisceau lumineux de ladite image primaire pour former une image secondaire ;

ledit premier système optique de formation d'image (K1) comprenant

un premier groupe de lentilles positives (GIP) ayant un pouvoir de réfraction positif ;

un premier groupe de lentilles négatives (G1N) ayant un pouvoir de réfraction négatif ;

un premier miroir réfléchissant concave (M1) dans lequel le faisceau lumineux provenant dudit premier objet (10) passe à travers ledit premier groupe de lentilles positives (GIP) et ledit premier groupe de lentilles négatives (G1N) vers ledit premier miroir concave (M1), et après réflexion par celui-ci passe de nouveau à travers ledit premier groupe de lentilles négatives (G1N) et ledit premier groupe de lentilles positives (G1P), formant de ce fait ladite image primaire ;

ledit second système optique de formation d'image (K2) comprenant

un second groupe de lentilles positives (G2P) ayant un pouvoir de réfraction positif ;

un second groupe de lentilles négatives (G2N) ayant un pouvoir de réfraction négatif ;

un second miroir réfléchissant concave (M2)

dans lequel le faisceau lumineux provenant de ladite image primaire passe à travers ledit second groupe de lentilles positives (G2P) et ledit second groupe de lentilles négatives (G2N), est réfléchi par ledit second miroir concave (M2) et après réflexion par celui-ci passe de nouveau à travers ledit second groupe de lentilles négatives (G2N) et ledit second groupe de lentilles positives (G2P), formant de ce fait ladite image secondaire.

2. Appareil d'exposition selon la revendication 1, dans lequel une distance focale dudit premier groupe de lentilles positives dans ledit premier système optique de formation d'image est $f_{GP}$, et une distance focale dudit premier groupe de lentilles négatives dans ledit premier système optique de formation d'image est $f_{GN}$, la relation suivante est satisfaite :

$$3 < | f_{GN} / f_{GP}|.$$

3. Appareil d'exposition selon la revendication 1 ou 2, dans lequel lorsqu'une distance focale dudit second groupe de lentilles positives dans ledit second système optique de formation d'image est $f_{GP}$, et une distance focale dudit second groupe de lentilles négatives dans ledit second système optique formation d'image est $f_{GN}$, la relation suivante est satisfaite :

$$3 < | f_{GN} / f_{GP}|.$$

4. Appareil d'exposition selon l'une quelconque des revendications 1 à 3, dans lequel ledit premier groupe de lentilles négatives inclut une lentille ménisque négative ayant une surface convexe en regard du côté du premier groupe de lentilles positives,

et dans lequel lorsqu'un rayon de courbure de la surface de la lentille de ladite lentille ménisque négative sur ledit côté premier groupe de lentilles positives est $r_{1N}$, un rayon de courbure d'une surface de lentille de ladite lentille ménisque négative sur un côté premier miroir réfléchissant concave est $r_{2N}$, une distance sur un axe optique depuis un point principal côté image vers ledit premier miroir réfléchissant concave, lequel côté image correspond audit côté du premier miroir réfléchissant concave de ladite lentille ménisque négative est $L_{NM}$, et une distance sur un axe optique depuis ledit premier objet audit premier miroir réfléchissant concave est TL, les relations suivantes sont satisfaites

$$- 30 < q < - 3$$

$$- 4 < L_{NM}/TL < 0,2$$

où $q = (r_{2N} + r_{1N})/(r_{2N} - r_{1N})$.

5. Appareil d'exposition selon l'une quelconque des revendications 1 à 4, dans lequel ledit second groupe de lentilles négatives inclut une lentille ménisque négative ayant une surface convexe en regard du côté second groupe de lentilles positives, et dans lequel lorsqu'un rayon de courbure d'une surface lentille de ladite lentille ménisque négative sur ledit côté second groupe de lentilles positives est $r_{1N}$, un rayon de courbure d'une surface de lentille de ladite lentille ménisque négative sur un côté second miroir réfléchissant concave est $r_{2N}$, une distance sur un axe optique depuis un point principal côté image vers ledit second miroir réfléchissant concave, lequel côté image correspond audit côté second miroir réfléchissant concave de ladite lentille ménisque négative est $L_{NM}$, et une distance sur un axe optique depuis ledit premier objet audit premier miroir réfléchissant concave est TL, les relations suivantes sont satisfaites :

$$- 30 < q < - 3$$

$$- 4 < L_{NM}/TL < 0{,}2$$

où $q = (r_{2N} + r_{1N}) / (r_{2N} - r_{1N})$.

**6.** Appareil d'exposition selon l'une quelconque des revendications 1 à 5, dans lequel lorsqu'une distance depuis un point principal côté image, lequel côté image correspond au côté premier miroir réfléchissant concaves dudit premier groupe de lentilles positives à un point principal côté image, lequel côté image correspond au côté premier miroir réfléchissant concave dudit premier groupe de lentilles négatives est $L_{GP-GN}$, et une distance sur un axe optique depuis ledit premier objet audit premier miroir réfléchissant concave est TL, la relation suivante est satisfaite :

$$0{,}35 < L_{GP-GN}/TL.$$

**7.** Appareil d'exposition selon l'une quelconque des revendications 1 à 6, dans lequel lorsqu'une distance depuis un point principal côté image, lequel côté image correspond au côté second miroir réfléchissant concave dudit second groupe de lentilles positives à un point principal côté image, lequel côté image correspond au côté second miroir réfléchissant concave dudit second groupe de lentilles négatives est $L_{GP-GN}$, et une distance sur un axe optique depuis ledit premier objet audit second miroir réfléchissant concave est TL, la relation suivante est satisfaite :

$$0{,}35 < L_{GP-GN}/TL.$$

**8.** Appareil d'exposition selon l'une quelconque des revendications 1 à 7, dans lequel lorsqu'un rayon de courbure dudit premier miroir réfléchissant concave dans ledit premier système optique de formation d'image est $r_M$, une distance focale dudit premier groupe de lentilles positives est $f_{GP}$, et une distance sur un axe optique depuis ledit premier objet audit premier miroir réfléchissant concave est TL, les relations suivantes sont satisfaites :

$$0{,}95 < | r_M/ TL| < 1{,}08$$

$$0{,}3 < f_{GP}/TL < 1{,}0.$$

**9.** Appareil d'exposition selon l'une quelconque des revendications 1 à 8, dans lequel lorsqu'un rayon de courbure dudit second miroir réfléchissant concave dans ledit second système optique de formation d'image est $r_M$, une distance focale dudit second groupe de lentilles positives est $f_{GP}$ et une distance sur un axe optique depuis ladite image primaire audit second miroir réfléchissant concave est TL, les relations suivantes sont satisfaites :

$$0{,}95 < | r_M/ TL| < 1{,}08$$

$$0{,}3 < f_{GP}/TL < 1{,}0.$$

**10.** Appareil d'exposition selon la revendication 1, dans lequel ledit premier groupe de lentilles négatives comporte une lentille positive et une lentille ménisque négative ayant une surface concave en regard dudit côté premier groupe de lentilles positives, dans l'ordre depuis le côté du premier groupe de lentilles positives,

et dans lequel ledit second groupe de lentilles négatives comporte une lentille positive et une lentille ménisque négative ayant une surface concave en regard dudit côté second groupe de lentilles de positives, dans l'ordre depuis le côté second groupe de lentilles positives.

**11.** Appareil d'exposition selon la revendication 1, dans lequel ledit premier groupe de lentilles négatives comporte une lentille ménisque négative adhérée audit premier miroir réfléchissant concave,
et dans lequel ledit second groupe de lentilles négatives comporte une lentille ménisque négative adhérée audit second miroir réfléchissant concave.

**12.** Appareil d'exposition selon la revendication 1, dans lequel ledit premier système optique de formation d'image comporte un premier élément réfléchissant pour dévier un faisceau lumineux provenant dudit premier objet vers ledit premier groupe de lentilles positives et pour dévier le faisceau lumineux provenant dudit premier groupe de lentilles positives vers ledit second système optique de formation d'image,
et dans lequel ledit second système optique de formation d'image comporte un second élément réfléchissant pour dévier le faisceau lumineux provenant dudit premier système optique de formation d'image vers ledit second groupe de lentilles de positives et pour dévier le faisceau lumineux provenant dudit second groupe de lentilles positives vers ledit second objet.

**13.** Procédé de fabrication d'un panneau d'affichage comprenant les étapes consistant à :

préparer un masque ;

préparer un substrat photosensible ; et

transférer par projection une image redressée réelle d'un motif sur ledit masque, sur ledit substrat photosensible en utilisant un appareil d'exposition selon l'une quelconque des revendications 1 à 12.

# Fig. 1

# Fig.2A

10a

# Fig.2B

FS

FSa

# Fig.2C

30a

Y

X

# Fig.3

Fig. 4

# Fig.5A

SPHERICAL
ABERRATION

N.A.=0.1

−0.14μm  +0.14μm

# Fig.5B

ASTIGMATISM

Y=1

−0.14μm  +0.14μm

# Fig.5C

COMA

+0.014μm

Y=1

−0.014μm

Y=0.75

Y=0.5

Fig. 6

# Fig. 7

EP 0 723 173 B1

EP 0 723 173 B1

# Fig.8A

## SPHERICAL ABERRATION

N.A.=0.1

-0.14μm  +0.14μm

# Fig.8B

## ASTIGMATISM

Y=1

-0.14μm  +0.14μm

# Fig.8C

## COMA

+0.014μm

Y=1

-0.014μm

Y=0.75

Y=0.5

# Fig.9

EP 0 723 173 B1

$K_1(K_2)$

$S_1(S_2)$

$G_{1P}(G_{2P})$

$G_{1N}(G_{2N})$

$L_{1P1}$  $L_{1P2}$  $L_{1P3}$

$L_{1N1}$  $L_{1N2}$

$A_X$

$(L_{2P1})$ $(L_{2P2})$ $(L_{2P3})$

$L_{2N1}$

$L_{2N2}$  $M_1(M_2)$

# Fig.IOA

SPHERICAL
ABERRATION

N.A.=0.1

-0.14μm  +0.14μm

# Fig.IOB

ASTIGMATISM

Y=1

-0.14μm  +0.14μm

# Fig.IOC

COMA

+0.014μm

Y=1

-0.014μm

Y=0.75

Y=0.5

EP 0 723 173 B1

# Fig. 11

$K_1(K_2)$

$S_1(S_2)$

$G_{1P}(G_{2P})$

$G_{1N}(G_{2N})$

$L_{1P1}$  $L_{1P2}$  $L_{1P3}$  $L_{1P4}$

$L_{1N1}$

$M_1(M_2)$

$A_X$

$(L_{2P1})(L_{2P2})(L_{2P3})(L_{2P4})$

$(L_{2N1})$

EP 0 723 173 B1

# Fig.12A

SPHERICAL
ABERRATION

N.A.=0.1

-0.14μm  +0.14μm

# Fig.12B

ASTIGMATISM

Y=1

-0.14μm  +0.14μm

# Fig.12C

COMA

+0.014μm

Y=1

-0.014μm

Y=0.75

Y=0.5

EP 0 723 173 B1

# Fig. 13

EP 0 723 173 B1

# Fig.I4A

SPHERICAL
ABERRATION

N.A.=0.15

-0.14μm  +0.14μm

# Fig.I4B

ASTIGMATISM

Y = I

-0.14μm  +0.14μm

# Fig.I4C

COMA

+0.014μm

Y=I

-0.014μm

Y=0.75

Y=0.5

EP 0 723 173 B1

Fig.15

# Fig.16A

SPHERICAL
ABERRATION

N.A.=0.1

-0.14μm    +0.14μm

# Fig.16B

ASTIGMATISM

Y=1

-0.14μm    +0.14μm

# Fig.16C

COMA

+0.014μm

Y=1

-0.014μm

Y=0.7

Y=0.5

EP 0 723 173 B1

# Fig.17

$K_1(K_2)$

$S_1(S_2)$

$G_{1P}(G_{1N})$

$L_{1P1}$ $L_{1P2}$ $L_{1P3}$ $L_{1P4}$

$G_{1N}(G_{2N})$

$L_{1N1}$

$M_1(M_2)$

$A_x$

$(L_{2N1})$

$(L_{2P1})(L_{2P2})(L_{2P3})(L_{2P4})$

EP 0 723 173 B1

# Fig. 18A

SPHERICAL
ABERRATION

N.A.=0.1

−0.14μm  +0.14μm

# Fig. 18B

ASTIGMATISM

Y=1

−0.14μm  +0.14μm

# Fig. 18C

COMA

+0.014μm

Y=1

−0.014μm

Y=0.7

Y=0.5

EP 0 723 173 B1

# Fig.19

$K_1(K_2)$

$S_1(S_2)$

$G_{1P}(G_{2P})$

$L_{1P1}$ $L_{1P2}$ $L_{1P3}$ $L_{1P4}$

$G_{1N}(G_{2N})$

$L_{1N1}$

$M_1(M_2)$

$A_X$

$(L_{2N1})$

$(L_{2P1})(L_{2P2})(L_{2P3})(L_{2P4})$

EP 0 723 173 B1

# Fig.20A

SPHERICAL
ABERRATION

N.A=0.1

- 0.14μm   +0.14μm

# Fig.20B

ASTIGMATISM

Y=1

-0.14μm  +0.14μm

# Fig.20C

COMA

+0.014μm

Y=1

-0.014μm

Y=0.7

Y=0.5

EP 0 723 173 B1

# Fig. 2I

EP 0 723 173 B1

Fig.22A

SPHERICAL
ABERRATION

N.A. =0.1

-0.14μm  +0.14μm

Fig.22B

ASTIGMATISM

Y=1

-0.14μm  +0.14μm

Fig.22C

COMA

+0.014μm

Y=1

-0.014μm

Y=0.7

Y=0.5

EP 0 723 173 B1

# Fig. 23

# Fig.24

EP 0 723 173 B1

# Fig.25A

# Fig.25B

# Fig.26A　Fig.26B　Fig.26C

SPHERICAL
ABERRATION

ASTIGMATISM

COMA

N.A.=0.1

Y=1

Y=1

$+0.014\mu m$

$-0.014\mu m$

Y=0.7

$-0.14\mu m$　$+0.14\mu m$

$-0.14\mu m$　$+0.14\mu m$

Y=0.5

EP 0 723 173 B1